(19) Europäisches Patentamt / European Patent Office / Office européen des brevets

(11) **EP 4 394 400 B1**

(12) **EUROPEAN PATENT SPECIFICATION**

(45) Date of publication and mention of the grant of the patent:
**12.02.2025 Bulletin 2025/07**

(21) Application number: **22216944.3**

(22) Date of filing: **28.12.2022**

(51) International Patent Classification (IPC):
**G01R 27/00** *(2006.01)*　　**G01N 27/00** *(2006.01)*

(52) Cooperative Patent Classification (CPC):
**G01R 27/00**

(54) **MEASUREMENT CIRCUIT AND METHOD TO MEASURE A PHYSICAL CHARACTERISTIC OF A DEVICE**

MESSSCHALTUNG UND VERFAHREN ZUR MESSUNG EINER PHYSIKALISCHEN EIGENSCHAFT EINER VORRICHTUNG

CIRCUIT DE MESURE ET PROCÉDÉ DE MESURE D'UNE CARACTÉRISTIQUE PHYSIQUE D'UN DISPOSITIF

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**03.07.2024 Bulletin 2024/27**

(73) Proprietors:
- **Leibniz-Institut für Festkörper- und Werkstoffforschung Dresden e.V.**
  **01069 Dresden (DE)**
- **Technische Universität Dresden**
  **01069 Dresden (DE)**

(72) Inventors:
- **KÖNYE, Viktor**
  **01099 Dresden (DE)**
- **DUFOULEUR, Joseph**
  **01187 Dresden (DE)**
- **FULGA, Cosma**
  **01099 Dresden (DE)**
- **BUDICH, Jan**
  **01097 Dresden (DE)**
- **VAN DEN BRINK, Jeroen**
  **01187 Dersden (DE)**

(74) Representative: **Viering, Jentschura & Partner mbB**
**Patent- und Rechtsanwälte**
**Am Brauhaus 8**
**01099 Dresden (DE)**

(56) References cited:
JP-A- 2006 010 572　　JP-A- 2013 053 858
US-A1- 2015 308 973　　US-A1- 2018 143 227

## Description

### Technical Field

Various aspects relate to a measurement circuit, a measurement device and to a method to measure a physical characteristic of a device.

### Background

In general, one may want to measure an electric resistance of an electronical component. Therefore, a voltage and a current applied to the electronical component are measured. According to Ohm's law, the electric resistance may be determined by calculating the quotient of the measured voltage value and the measured current value.

However, if the electric resistance becomes too large, the voltage and current measurements may be difficult to be measured. Briefly, the high resistance of the electric component may be close or may be even higher than an internal measuring-resistance of the voltage measurement device or the voltage required to measure reasonable currents becomes too large. Therefore, the measurement of the resistance of the electronical component becomes unprecise.

US 2018/0143227 A1 describes methodologies and systems for testing the performance parameters of a power converter. The testing system involves a multi-channel monitoring device with specific channels dedicated to monitoring the switch voltage and output voltage of the power converter simultaneously. Additionally, the system includes a set of processors responsible for generating and displaying various waveforms, such as an inductor current waveform, which approximates the current flowing through the inductor of the power converter. Other waveforms, such as output current and inductor voltage waveforms, can also be generated during the testing process. Furthermore, an arbitrary wave generator is employed to inject different signals into the power converter during testing.

US 2015/308973 A1 describes a method and apparatus for measuring the electrical properties of biological cells. The method employs switching excitation with a sinusoidally amplitude-modulated current, combined with a real-time estimation algorithm to extract a phase-shifted sinusoidal voltage output. This algorithm utilizes a unique time-domain formulation, ensuring accurate and continuous measurements with high temporal resolution.

JP 2006 010572 A describes a method of measuring an electric characteristic of an electronic component capable of measuring easily and accurately the electric characteristic of a small-sized measured object, without damaging the measured object, and a measuring instrument therefor. The object under measurement makes contact with the first and second contacts. During the electric characteristic measurement, a tester control unit manages a constant-current power source to initiate an impressed current on the object via the contacts, starting from a second current value surpassing the first current value for measurement. Subsequently, the current is continuously decreased from the second current value to the first current value. The tester control unit obtains a measurement result using a voltmeter under the condition where the impressed current is set at the first current value on the measured object via the contacts.

JP 2013 053858 describes a device designed for measuring the electric characteristics of a composite material. The apparatus includes a ground plate and insulation support members placed at predetermined intervals to support a plate-shaped composite material formed in a regular n-gon (where n is an integer of five or more) in relation to the ground plate. Multiple electrodes are individually affixed to respective sides of the composite material, each connected to the ground plate via multiple electric wires. At the center of the composite material, there is an input electrode. A current generation part, connected to both the input electrode and the ground plate, administers electric current to the input electrode. To measure the currents in the multiple electric wires, the device incorporates current sensors.

### Brief Description of the Drawings

In the drawings, like reference characters generally refer to the same parts throughout the different views. The drawings are not necessarily to scale, emphasis instead generally being placed upon illustrating the invention. The invention is defined by the independent claims. Further embodiments are defined by the dependent claims.

In the following description, various aspects of the invention are described with reference to the following drawings, in which:

Figures 1 to 5 depict schematically a measurement device according to various aspects.
Figures 6A and 6B depict schematically a first-type sub circuit according to various aspects.
Figures 6C and 6D depict schematically a mirrored first-type sub circuit according to various aspects.
Figures 7A and 7B depict schematically a second-type sub circuit according to various aspects.
Figures 7C and 7D depict schematically a mirrored second-type sub circuit according to various aspects.
Figures 8A, 8B, 9, and 10 depict schematically a measurement device according to various aspects.
Figure 11 depicts a method for determining a physical characteristic according to various aspects.

**EP 4 394 400 B1**

Figures 12A, 12B, 13A, 13B, 14A, and 14B depict schematically a measurement device for an electric system according to various aspects.

Figure 15 illustrates a diagram showing the change of eigenvalue according to various aspects.

Figures 16A and 16B depict schematically a measurement device for an electric system according to various aspects.

Figures 17A and 17B illustrate diagrams showing measurement results for a measurement device according to various aspects and for conventional measurement devices.

## Description

The following detailed description refers to the accompanying drawings that show, by way of illustration, specific details, and aspects in that the invention may be practiced. These aspects are described in sufficient detail to enable those skilled in the art to practice the invention. Other aspects may be utilized, and structural, logical, and electrical changes may be made without departing from the scope of the invention. The various aspects are not necessarily mutually exclusive, as some aspects may be combined with one or more other aspects to form new aspects. Various aspects are described in connection with methods and various aspects are described in connection with devices. However, it may be understood that aspects described in connection with methods may similarly apply to the devices, and vice versa.

According to various aspects, a matrix that is not Hermitian may be referred to herein as non-Hermitian. In more detail, a Hermitian matrix, also referred to as self-adjoint matrix, is a complex square matrix that is equal to its own conjugate transpose. In some aspects, in a Hermitian matrix, a Matrix-element in the i-th row and j-th column is equal to the complex conjugate of the element in the j-th row and i-th column, for all indices i and j. In contrast, a non-Hermitian matrix does not fulfill this requirement.

According to various aspects, one or more characteristic properties of a device may be measured and/or determined herein. A property that may be related to a main function of the device may be referred to as a characteristic electrical property of the device. With respect to electronic components, a characteristic electronic property of an electrical resistor is an electrical resistance, a characteristic electronic property of an electrical inductor is an inductivity, and a characteristic electronic property of an electrical capacitor is an electrical capacitance. However, it is understood that an electrical capacitor has a negligible resistance associated therewith and that an electrical inductor has a negligible electrical resistance associated therewith and so forth.

According to various aspects, the term "probe element" as used herein may refer to a passive electronic element or another component (such as a valve, a thermal resistor, as examples) having, for example, at least one known (e.g., a predefined or measured) characteristic property (e.g., a characteristic physical property). The characteristic property may be the main property to characterize the passive element. The type of the passive element and/or the characteristic property may be based on the actual system.

In an electrical system a probe element, also referred to as electric probe element, may be a capacitor having a known capacitance, an inductor having a known inductance, or a resistor having a known resistance.

In a thermal system, a probe element, also referred to as thermal probe element, may be thermal resistor, having a known thermal resistance.

In a fluid system a probe element, also referred to as fluid probe element, may be a check valve, a hydraulic capacitor (e.g., an elastic membrane that is not permeable for fluid), a hydraulic inductor (e.g., a heavy paddlewheel) or a hydraulic resistor (e.g., a pipe, a valve).

Herein, an active element may refer to an element that is configured to receive a physical input and to output a modification of the physical input as a physical output (e.g., the physical output may be different, e.g., increased or decreased, with respect to the physical input). In some aspects, in an electric system, the active element may be an operational amplifier such as a voltage amplifier, a current amplifier, a quantum hall regime, as examples. In some aspects, in a thermal system an active element (more specific a thermally active element) may include (e.g., may be) a heat reservoir and a valve (e.g., one-way valve) to control a heat flow (e.g., limit the heat flow to a heat flow in only one direction), for example. In another example, an active element of a thermal system may be part of or may include a thermal quantum hall device. In some aspects, in a fluid system an active element (more specific a fluid dynamic active element) may include (e.g., may be) a fluid reservoir and a valve (e.g., one-way valve) to control a fluid flow (e.g., limit the fluid flow to a fluid flow in only one direction), for example. According to various aspects, the active element may be connected and/or may include a power source (e.g., an electric power source, a pressure source, a heat source, a fluid source, as examples) or a particle source.

Herein, elements may be connected via nodes. A node may be an element to describe a connection between different elements. Furthermore, a node may be a splitting point and/or a merging point of a connection line (e.g., a pipe, a wire, a thermal connection, as examples), at that the connection line is split up in two or more connection lines and/or at that two or more connection lines merge into one connection line. Illustratively, a node may include, e.g., may be, by a coupling-device, a junction, a port or a terminal, as examples.

Furthermore, terminals that are directly connected to the same node, may be subjected to the same physical

3

property that may be based on the system. For example, in an electrical system, terminals of electric devices that are connected to the same node, may be subjected to the same electric potential, e.g., the same electrical voltage. For example, in an electrical system, terminals of electric devices that are connected to the same node, may be connected via an electrical conductor, e.g., having an electric conductivity greater than $10^5$ S/m (e.g., at 20°C and 1 bar). For example, in a thermal system, terminals of devices that are connected to the same node, may be subjected to the same temperature. For example, in a thermal system, terminals of devices that are connected to the same node, may be connected via a thermal conductor, e.g., having a thermal conductivity greater than 10 W/(mK) (e.g., at the current temperature and subjected to a working pressure, as an example). For example, in a fluid system, terminals of devices that are connected to the same node, may be subjected to the same pressure.

According to various aspects, physical quantities may be compared herein, and a first physical quantity $PQ_1$ may be substantially greater than a second physical quantity $PQ_2$ that may be illustrated by $PQ_1 \gg PQ_2$. Compared to the first physical quantity $PQ_1$, the second physical quantity $PQ_2$ may be neglected, i.e., the second physical quantity $PQ_2$ or at least the quotient of the second and the first physical quantity $PQ_2/PQ_1$ may be considered to be substantially zero (e.g., less than 0.01). Regarding the inverse values, this contemplation may differ, i.e., if $PQ_1 \gg PQ_2$, then $1/PQ_1 \ll 1/PQ_2$. Therefore, the inverse of the first physical quantity $PQ_1$ may be negliable in some aspects with respect to the inverse of the second physical quantity $PQ_2$.

Various aspects, as described herein, may be based on the finding, that, if a conductance matrix is non-Hermitian, it may show enhanced spectral sensitivity. In this case, the voltage (or current) on specific nodes may become extremely sensitive to the value of the resistance between the first and the last node onto that a device under test may be connected to. Therefore, those values may be a very relevant quantity for measuring a resistance or other electrical properties of the device under test that may be somehow related to the electric resistance. Furthermore, it was discovered, that a sensitivity to be expected regarding the measurement may depend exponentially onto a number of nodes, and subsequently onto a number of sources, e.g., voltage sources and or current sources.

Various aspects relate to a current injection into a measurement device, e.g., at an injection node as example. A current injection means that a current enters the measurement device. Furthermore, various aspects relate to an electrical current injection, i.e., an electrical current that enters the measurement device, e.g., at a current injection node as example. The electrical current may be either voltage controlled or current controlled.

The voltage control may be performed by setting a voltage, i.e., a predefined voltage, at the corresponding current injection node and by measuring a resulting current flow to the corresponding current injection node. The setting of the voltage may also be referred to as applying a voltage, e.g., applying a predefined voltage, to the corresponding current injection node. For example, the current flow I may be a function of the set voltage U, i.e., the predefined voltage, and a conductivity value G: $I = GU$. Furthermore, if multiple voltages $\vec{U}$ are applied to multiple injection nodes of the measurement device, multiple currents $\vec{I}$ may be measured and/or be a function of a conductivity matrix currents G and the applied voltages $\vec{U}$: $\vec{I} = G\vec{U}$, where the vector components are constituted by the different applied voltages and measured currents. An advantage of the voltage controlled current injection may be that potential leakage currents, which may affect a measurement result, may be compensated.

The current control may be performed by setting a current flow, a predefined current, to the corresponding current injection node and by measuring a resulting voltage at the corresponding current injection node. The setting of the current flow may also be referred to as applying a current, e.g., applying a predefined current, to the corresponding current injection node. For example, the measured voltage U may be a function of the injected current I, i.e., the predefined current, and a resistivity value $R: U = RI$. Furthermore, if multiple currents $\vec{I}$ are injected to multiple injection nodes of the measurement device, multiple voltages $\vec{U}$ may be measured and/or may be a function of a resistivity matrix R and the injected currents $\vec{I}$: $\vec{U} = R\vec{I}$. The injected current I may be measured by a corresponding voltage and predefined resistor and/or using a coil and a corresponding magnetic field that may be caused by the injected current $\vec{I}$.

Several aspects are described herein related to various figures in which a voltage controlled current injection is shown and referred to. A voltage controlled current source may be used to perform the voltage controlled current injection. For example, the voltage controlled current source may be configured to control a current output using a control voltage. For example, the control voltage may be proportional to the output current. However, it should be understood that the voltage controlled current injection is an example of a possible way to inject currents into the measurement device and that other configurations can be used in a same or similar way. As another example, a current controlled current injection can be used, wherein a current controlled current source may be used to perform the current controlled current injection. For example, the current controlled current source may be configured to control a current output using a control current. For example, the control current may be proportional to the output current.

Various aspects relate to a variation of a physical characteristic. Herein, the variation of a physical characteristic may relate to a value which is represented as a function of a predetermined value, e.g., a difference and/or a relative value. For example, a variation of a physical characteristic may represent an increase or a decrease of the corresponding physical characteristic. The variation may be caused by a variation of the measurement device, e.g., by adding or removing an element to the measurement device. For example, the variation of the physical characteristic may be a deviation based on a predetermined value. For example, the variation of the physical characteristic may be a difference of the measured value to the predetermined value.

For example, in an electrical system, the physical characteristic may be an electrical resistance R as an example. A corresponding variation of the electrical resistance $\Delta R$ may be based on an initially determined electrical resistance $R_0$, e.g., may be a predetermined electrical resistance. For example, the variation of the electrical resistance $\Delta R$ may be measured as a difference to the initially determined electrical resistance $R_0$. For example, the variation may lead to another electrical resistance $R_1$ that may be determined. The variation of the electrical resistance $\Delta R$ may be a function of the initially determined resistance $R_0$ and the other electrical resistance $R_1$. Furthermore, the variation of the electrical resistance $\Delta R$ may correspond to a relative value, e.g., $\Delta R/R_1$. For example, the initial resistance $R_0$ and the other electrical resistance $R_1$ may be determined using a measured voltage and/or a measured current. In one example, the resistances may be represented by the measured voltages, i.e., an initial Voltage $U_0$ and another voltage $U_1$. Based on the measured voltages a variation $\Delta U$ and a corresponding relative value, e.g., $\Delta U/U_1$ may be determined.

According to various aspects it was discovered that it is possible to provide a measurement device for any physical system, having three physical parameters that may be correlated via a non-Hermitian matrix, e.g., a non-Hermitian correlation matrix as an example. In more detail, a first of the three physical parameters may act as an input parameter, i.e., a physical parameter that may be predetermined and may be injected into the measurement device. A second of the three physical parameters may act as an output parameter, i.e., a parameter to be measured. The third parameter, which may be a characteristic parameter for the physical system and is to be analyzed, is included in the non-Hermitian matrix.

In the following this will be exemplarily described with respect to an electronic system, wherein the first physical parameter may be an electric current, the second physical parameter may be an electric voltage, and the third physical parameter may be an electric resistance, an electric conductance, an electric inductance or any other electrical characteristic property that has to be obtained from a device under test. In such a system, an active element may be realized by an operational amplifier. The components of the corresponding measurement device may be electrically connected, e.g., via a galvanic connection.

However, as stated before, it should be understood, that the overall principle of the measurement may be applied to other physical systems mutatis mutandis, such as a thermal system, or a fluid system, e.g., a flow-system.

In a thermal system, the first physical parameter (i.e., the injected parameter) may be a predetermined heat flow and the second physical parameter, i.e., the measured parameter, may be a temperature that may be measured or vice versa. The third physical parameter, i.e. the characteristic parameter to be analyzed, may be a thermal resistance or thermal conductivity. An active device in the thermal system may include a heat reservoir and a valve or may be a device having a similar functionality. A power source in the thermal system may include, e.g., may be, a heater device. The components of the corresponding measurement device may be connected via a heat-conductive connection.

In a fluid system, e.g., a system having a flowing fluid, the first physical parameter (i.e., the injected parameter) may be a volumetric flow rate and the second physical parameter, i.e., the measured parameter, may be a pressure that may be measured or vice versa. The third physical parameter, i.e. the characteristic parameter to be analyzed, may be a flow resistance. An active device in the fluid system may include a fluid reservoir and a valve or may be a device having a similar functionality. A power source in the fluid system may include, e.g., may be, a pumping device. The components of the corresponding measurement device may be connected such that a fluid may flow within the measurement device, e.g., via pipes and/or tubes.

According to various aspects a measurement device 100 is provided. The measurement device may be configured to measure a characteristic property of a device to be analyzed 10 that is represented by a dash-dotted-line. In one example, the device to be analyzed 10 may be connected to the measurement device 100 during the measurement of the characteristic property. In another example, the device to be analyzed may be disconnected from the measurement device 100 during the measurement of the characteristic property. The measurement device 100 may include a first measurement node 102 and a second measurement node 104, onto that the device to be analyzed 10 may be connected to. Furthermore, the measurement device may include a measurement circuit 200 that is coupled to the first measurement node 102 and the second measurement node 104. The measurement circuit 200 may include at least three injection nodes 210, wherein each of the at least three injection nodes 210 is configured to receive the first physical parameter.

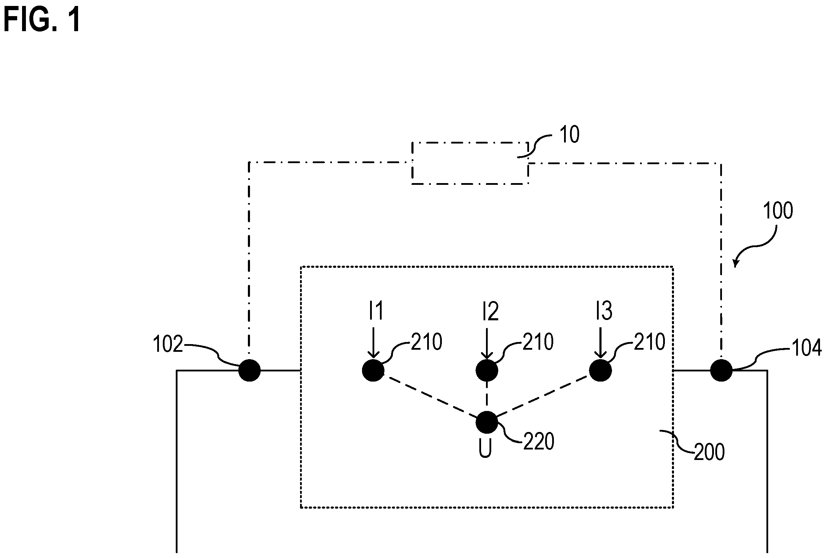

In an electronic system the at least three injection nodes 210 may referred to as at least three current injection nodes. The at least three current injection nodes may be configured to inject at least three currents (I1, I2, I3) into the measurement circuit 200, as exemplarily shown in **Fig.1.** In a thermal system, the at least three injection nodes 210 may be referred to as at least heat-flow injection nodes. The at least heat-flow injection nodes may be configured to receive at least three heat flows that are injected into the measurement circuit 200. In a fluid system, the at least three injection nodes 210 may be referred to as at least fluid injection nodes. The at least fluid injection nodes may be configured receive at least three fluid-flowrates that are injected into the measurement circuit 200.

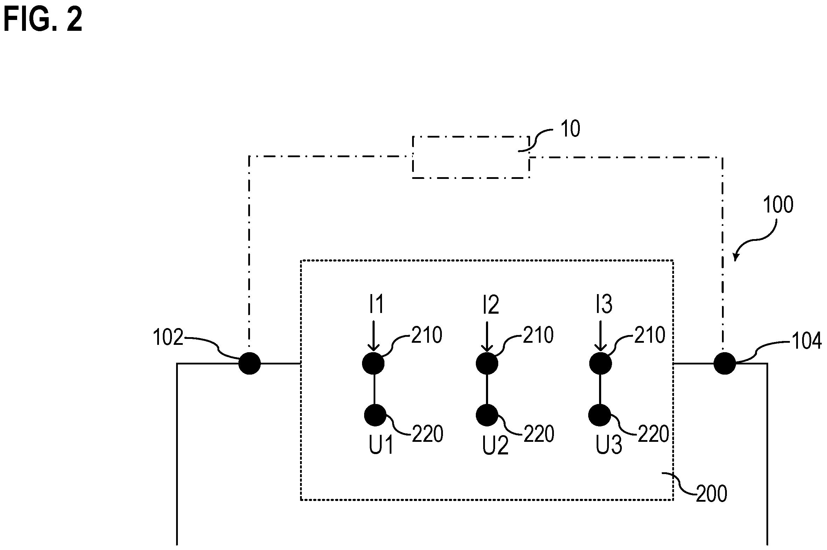

**Fig.2** depicts a measurement device 100 according to various aspects including at least three injection nodes 210. Each of the at least three injection nodes 210 may be connected to a sensing node 220. A sensing node may be configured to allow a measurement for the second physical parameter at one of the at least three injection nodes 210. For example, the sensing node may be configured to be connected to a corresponding measurement device to measure the second physical parameter after and/or during injection of the first physical parameter into the measurement device. The measurement circuit 200 may include one or more sensing nodes 220. In one embodiment, each of the at least three injection nodes 210 may be connected to one of the more sensing nodes 220, respectively, as shown in Fig.2. However, the number of used sensing nodes 220 may be adapted to the measurement device 100.

In an electronic system, the sensing node 220 may be configured to allow for a current measurement and/or a voltage measurement at one of the at least three injection nodes 210. For example, the sensing node 220 may be configured to be connected to a measurement device, e.g., to a voltage-measurement device and/or to a current measurement device. For example, a sensing node 220 that is configured to measure a current may be referred to as a current sensing node. For example, a sensing node 220 that is configured to measure a voltage may be referred to as a voltage sensing node. For example, a sensing node that is configured to measure a current and/or a voltage may be referred to as a current/voltage sensing node. In a thermal system, the sensing node 220 may be configured to allow for a temperature measurement at one of the at least three injection nodes 210. For example, the sensing node 220 may be configured to be connected to a temperature measurement device, e.g., a thermometer. In a fluid system, the sensing node 220 may be configured to allow for a pressure measurement at least one of the three injection nodes 210 at one of the at least three injection nodes 210. For example, the sensing node 220 may be configured to be connected to a pressure measurement device, e.g., a manometer.

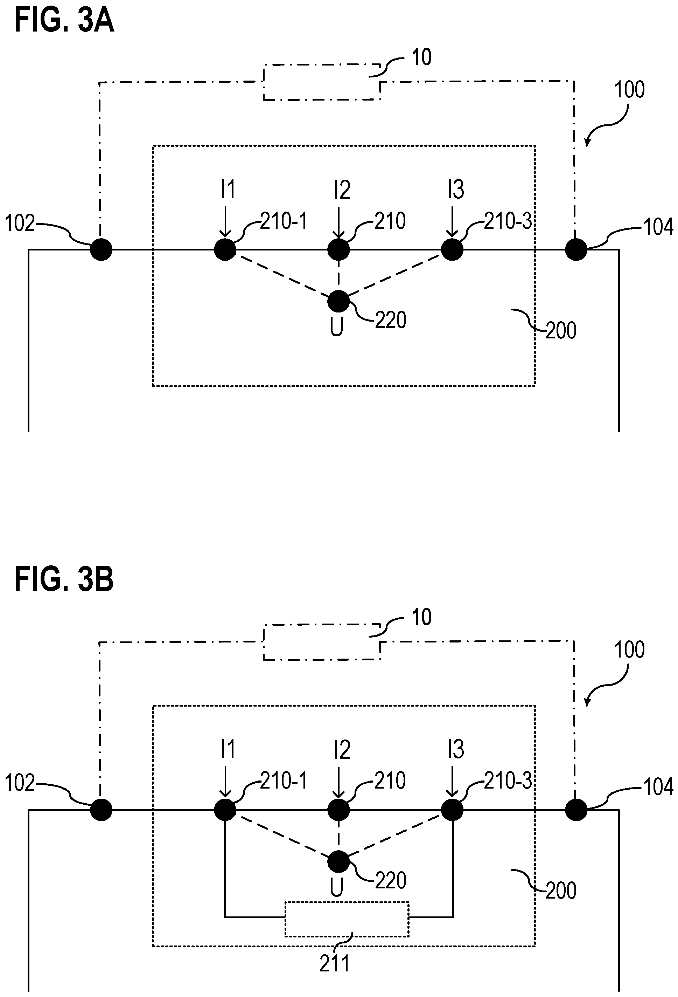

According to various aspects, the at least three injection nodes 210 may form a series connection, as shown in **Fig.3A.** Illustratively the at least three injection nodes 210 may form a row of injection nodes, in that adjacent injection nodes are connected. Furthermore, injection nodes of the at least three injection nodes 210 that are not adjacent to each other may be connected to a parallel connection 211 that is connected in parallel to the row of injection nodes, as illustrated in **Fig.3B.**

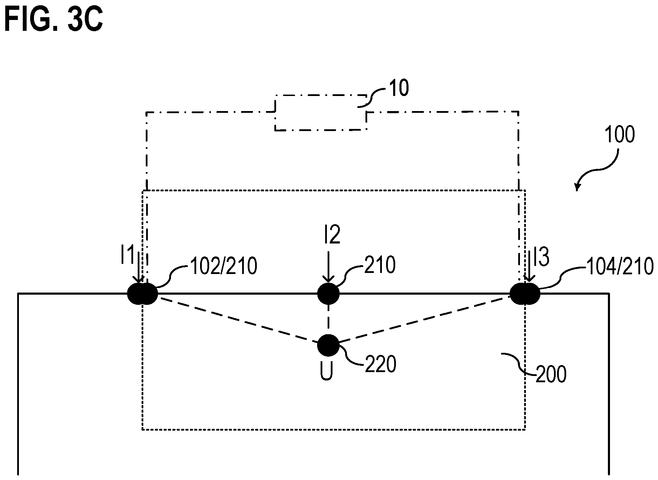

**Fig.3C** depicts a measurement device 100 according to various aspects may include a measurement node and an injection node that are adjacent to each other and may be realized as common connection node. In more detail, the first measurement node 102 and one of the at least three injection nodes 210 may be realized as a first connection node 102/210. Alternatively, or additionally, the second measurement node 104 and another of the at least three injection nodes 210 may be realized as a second connection node 104/210.

Furthermore, in an electrical system, directly adjacent nodes, i.e. any nodes without any further elements in between, may be on the substantially same electrical potential. For example, the first measurement node 102 and one of the at least three injection nodes 210 that do not have any other electrical components in between, may be on the substantially same electrical potential. Similarly, in a thermal system, directly adjacent nodes, may have the substantially same temperature and in a fluid system, the substantially same pressure may be present at directly adjacent nodes.

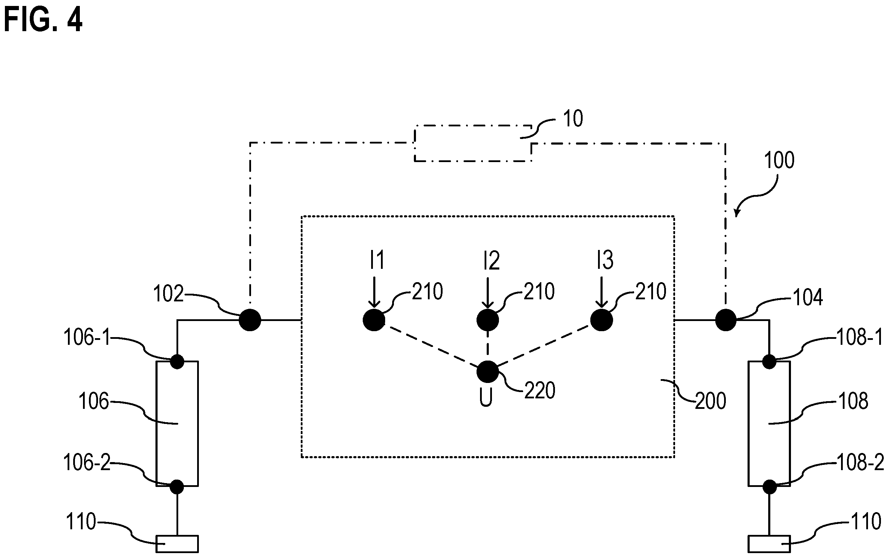

**Fig.4** depicts a measurement device 100 according to various aspects. The measurement device 100 may further include a first probe element 106 and/or a second probe element 108. As explained before, the type of the probe element may be based on the actual system in that the measurement device is used, e.g., in an electric System an electric probe element may be a passive electronic element, such as a resistor, a capacitor and/or an inductor.

The first and the second probe element may differ with respect to their physical property, e.g., the physical property of the first probe element may be greater or less than the physical property of the second probe element. For example, in an electric system, an electric resistance of the first electric probe element (e.g., a first resistor) may be greater or less than an electric resistance of the second electric probe element (e.g., a second resistor).

According to various aspects, the first probe 106 element, may have a first terminal 106-1 and a second terminal 106-2. Illustratively, the first probe element 106 may have an input terminal and an output terminal and/or may be at least a two-terminal component. The first terminal 106-1 of the first probe element 106 may be connected to the first measurement node 102. The second terminal 106-2 of the first probe element 106 may be connected to a reservoir 110. The reservoir 110 may be configured to have a substantially constant second physical property (i.e., the measured property). For example,. the second physical property may be independent of an amount that is injected from the reservoir to the measurement device 100. As an example, the reservoir may be a fluid reservoir configured to provide a pressure to the first probe element 106. However, in this example the provided pressure should be independent of an amount of a fluid which may flow from the fluid reservoir to the first probe element 106 or vice versa. In another example, the reservoir may be a ground potential, e.g., a mass. In this example, the ground potential does not change, independent of the current flowing to the reservoir, i.e., the ground potential.

For example, in an electronic system the reservoir 110 may be a ground potential that does not change its electric potential due to a current being injected to the measurement device (e.g., into one of the at least 3 current injection nodes). In a thermal system, the reservoir may be a thermal reservoir, a thermal energy reservoir or a thermal bath, having a heat capacity that is so large, that its temperature does not change due a heat flow being injected to the measurement device. In a fluid system, the reservoir may be a fluid reservoir that is configured that a pressure does not change due to a fluid current being injected to the measurement device. For example, a fluid reservoir may be a large geometric volume that may receive and absorb an arbitrary fluid volume from the measurement device.

According to various aspects, the second probe 108 element, may have a first terminal 108-1 and a second terminal 108-2. Illustratively, the second probe element 108 may have an input terminal and an output terminal and/or may be at least a two-terminal component. The first terminal 108-1 of the second probe element 108 may be connected to the second measurement node 104. The second terminal 108-2 of the second probe element 108 may be connected to a reservoir 110 (e.g., the same reservoir 110 as the first probe element). The reservoir 110 may be configured to have a substantially constant second physical property (i.e., the measured property) as described before.

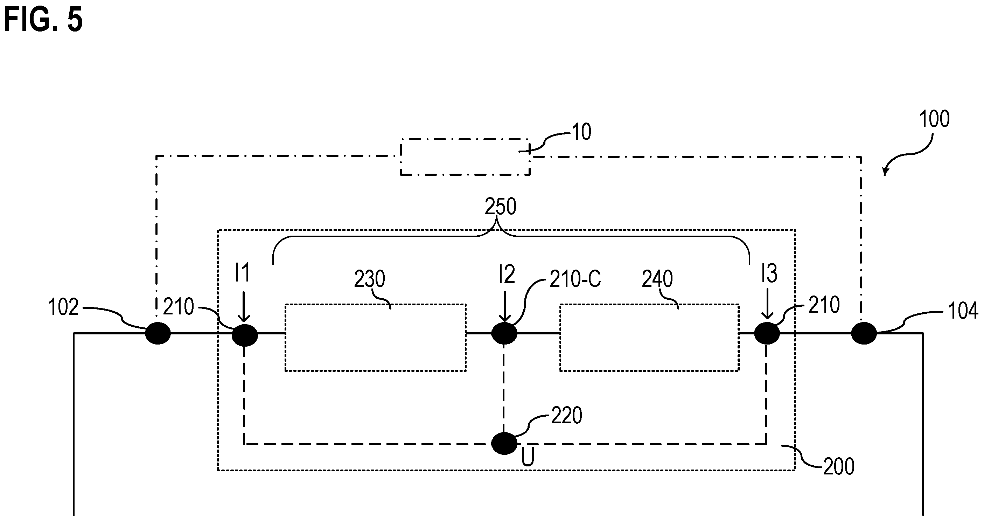

**Fig.5** depicts a measurement device 100 according to various aspects. The measurement device 100 may include a measurement circuit 200. According to various aspects, the measurement circuit 200 may include various sub circuits. According to various aspects the measurement circuit 200 may include a first-type sub circuit 230 and a second-type sub circuit 240. The first-type sub circuit 230 and the second-type sub circuit 240 may be connected via one of the at least three injection nodes 210. Illustratively, the first-type sub circuit 230, one of the at least three injection nodes 210, and the second-type sub circuit 240 may form a series connection that may be referred to as a sub circuit row 250. The injection node within the sub circuit row 250 may be referred to as an interconnect injection node 210-C.

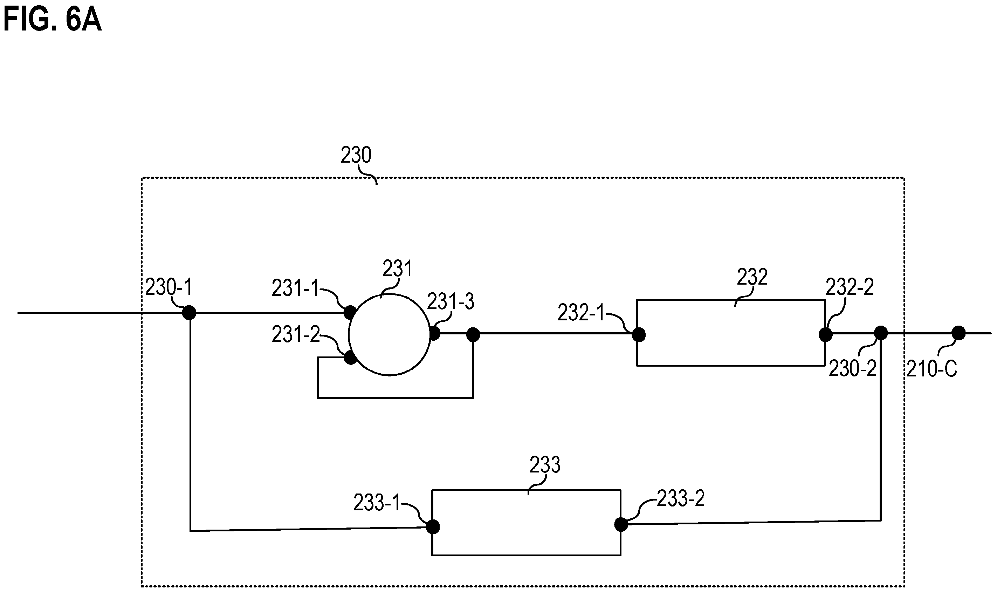

**Fig.6A** depicts a first-type sub circuit 230 according to various aspects. According to various aspects, the first-type sub circuit 230 may include a first active element 231, first sub-circuit probe-element 232, and a second sub-circuit probe-element 233. The first active element 231 and the first sub-circuit probe-element 232 may be connected in series. The first active element 231 and the first sub-circuit probe-element 232 may be connected in parallel with the second sub-circuit probe-element 233.

According to various aspects the first active element 231 may be an active element as described herein. The first active element 231 may include a first input terminal 231-1, a second input terminal 231-2, and an output terminal 231-3. The second input terminal 231-2 and the output terminal 231-3 of the first active element 231 may be directly connected to each other. With other words, the output of the first active element 231 may act as one input of the same. Furthermore, the first active element 231 may be connected to a power supply (not shown) configured to supply the first active element 231 with power.

According to various aspects the first sub-circuit probe element 232 may be a probe element as described herein. Briefly, it may be a passive element that type may be based on the system and that may be described by its known characteristic property. For example, in an electric system, the first sub-circuit probe-element 232 may be an electric resistor, an electric inductor, or an electric capacitor, as described above.

According to various aspects, the characteristic property of the first sub-circuit probe-element 232 may be the same as the characteristic property first probe-element 106 of the measurement device 100, such as both may be resistances (e.g., electric, thermal, hydraulic) or capacitances, as examples. For example, the characteristic property of the first sub-circuit probe-element 232 may differ less than 25%, e.g., less than 10%, less than 5%, less than 1%, less than 0,1% from the characteristic property first probe-element 106 of the measurement device 100. A lesser difference between the characteristic properties of the first sub-circuit probe-element 232 and the characteristic properties of the first probe-element 106 may lead to a more effective measurement, e.g., a lesser difference may simplify the non-Hermitian matrix, describing properties of the measurement device.

According to various aspects the first sub-circuit probe-element 232 may include an input terminal 232-1 and an output terminal 232-2. The input terminal 232-1 of the first sub-circuit probe-element 232 may be connected to the output terminal 231-3 of the first active element 231.

According to various aspects the second sub-circuit probe element 233 may be a probe element as described herein. Briefly, it may be a passive element that type may be based on the system and that may be described by its known characteristic property. For example, in an electric system, the second sub-circuit probe-element 233 may be an electric resistor, an electric inductor, or an electric capacitor, as described above.

According to various aspects, the characteristic property of the second sub-circuit probe element 233 may be the same as the characteristic property second probe-element 108 of the measurement device 100, such as, both may be resistances (e.g., electric, thermal, hydraulic), capacitances, as examples. For example, the characteristic property of the second sub-circuit probe element 233 may differ less than 25%, e.g., less than 10%, less than 5%, less than 1%, less than 0,1% from the characteristic property second probe-element 108 of the measurement device 100. A lesser difference between the characteristic properties of the second sub-circuit probe element 233 and the characteristic properties of the second probe-element 108 may lead to a more effective measurement, e.g., a lesser difference may simplify the non-Hermitian matrix, describing properties of the measurement device.

The second sub-circuit probe-element 233 may include an input terminal 233-1 and an output terminal 233-2. The input terminal 233-1 of the second sub-circuit probe-element 233 may be connected to the input terminal 231-1 of the first active element 231. The output terminal 233-2 of the second sub-circuit probe-element 233 may be connected to the output terminal 232-2 of the first sub-circuit probe-element 232.

For example, the first-type sub circuit 230 may include an input node, referred to as first-type sub circuit input node 230-1, and an output node, referred to as first-type sub circuit output node 230-2. The first-type sub circuit input node 230-1 may represent an input to the first-type sub circuit 230.

The first-type sub circuit input node 230-1 may be connected to an injection node of the at least three injection nodes 210. Furthermore, the first-type sub circuit input node 230-1 may be connected to the first active element 231 and to the third sub-circuit probe element 233. For example, the first-type sub circuit input node 230-1 may be connected to the input terminal 231-1 of the first active element 231. For example, the first-type sub circuit input node 230-1 may be connected to the input terminal 233-1 of the third sub-circuit probe element 233.

The first-type sub circuit output node 230-2 may be connected to the interconnect injection node 210-C of the at least three injection nodes 210. Furthermore, the first-type sub circuit output node 230-2 may be connected to the second sub-circuit probe element 232 and to the third sub-circuit probe element 233. For example, the first-type sub circuit output node 230-2 may be connected to the output terminal 232-2 of the second sub-circuit probe element 232. For example, the first-type sub circuit output node 230-2 may be connected to the output terminal 233-2 of the third sub-circuit probe element 233.

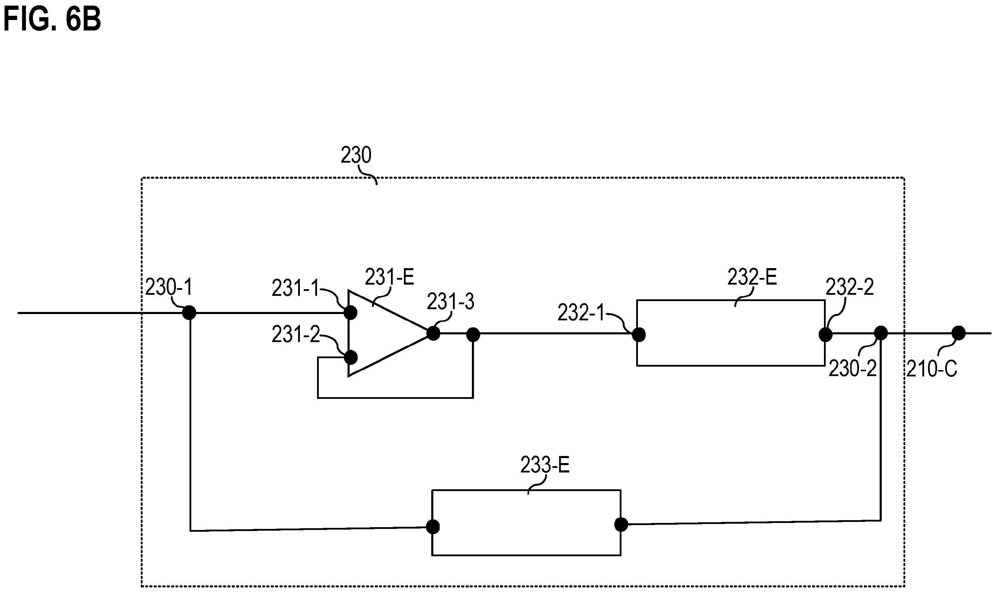

Fig.6B illustrates exemplarily a first-type sub circuit 230 according to various aspects that relates to an electrical system. For example, the first sub-circuit probe element 232 shown in Fig.6A may be an electric probe element, i.e., a first sub-circuit electric probe element 232-E, such as an electric resistor, an electric capacitor, or an electric inductor. Furthermore, the second sub-circuit probe element 233 shown in Fig.6A may be an electric probe element, i.e., a second sub-circuit electric probe element 233-E, such as an electric resistor, an electric capacitor, or an electric inductor. Additionally, the first active element 231 may be an electric operational amplifier, i.e. a first electric operational amplifier 231-E. The other features described above with respect to the first-type sub circuit 230 in general pertain mutatis mutandis to the first-type sub circuit 230 relating to an electrical system.

According to various aspects the first active element 231 the first-type sub circuit 230 is an asymmetric circuit that causes a preferred direction in which the first-type sub circuit 230 may be passed.

This direction may be altered, by mirroring the first-type sub circuit 230. For example, the first-type sub circuit 230 may be mirrored that may be also referred to as mirror-inverted by rotating the first-type sub circuit 230 about 180°. However, the injection nodes of the at least three injection nodes, which are connected to the first-type sub circuit 230 may remain at their position. As a consequence, an injection node of the at least three injection nodes, which was connected to the first-type sub circuit output node before the mirroring, will be connected to the first-type sub circuit input node after the mirroring and vice versa.

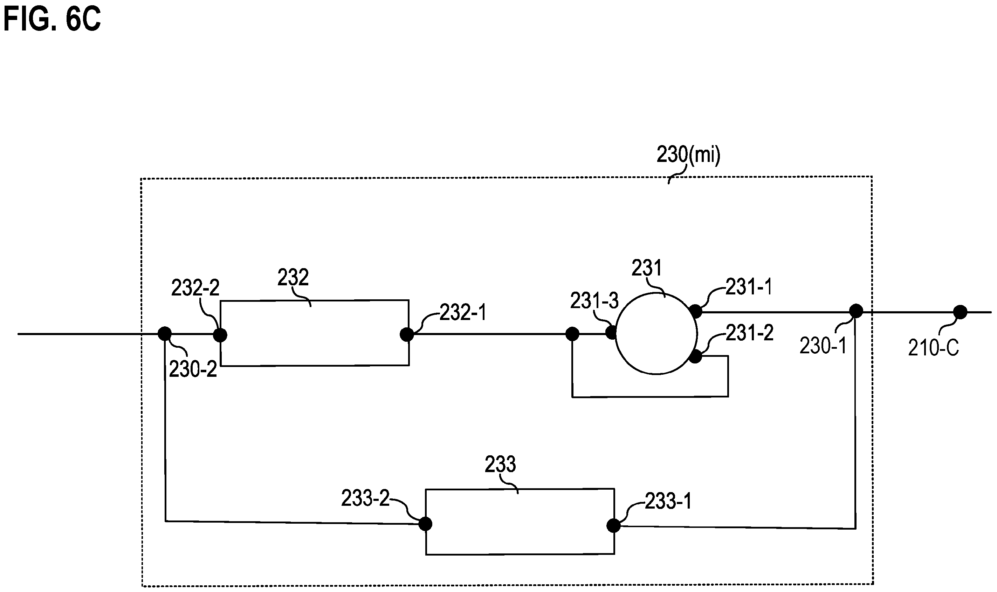

**Fig.6C** shows a mirror-inverted first-type sub circuit 230(mi) according to various aspects. As a consequence, the first-type sub circuit output node 230-2 may not be connected to the interconnect injection node 210-C of the at least three injection nodes. Instead, the first-type sub circuit input node 230-1 may be connected to the interconnect injection node 210-C of the at least three injection nodes.

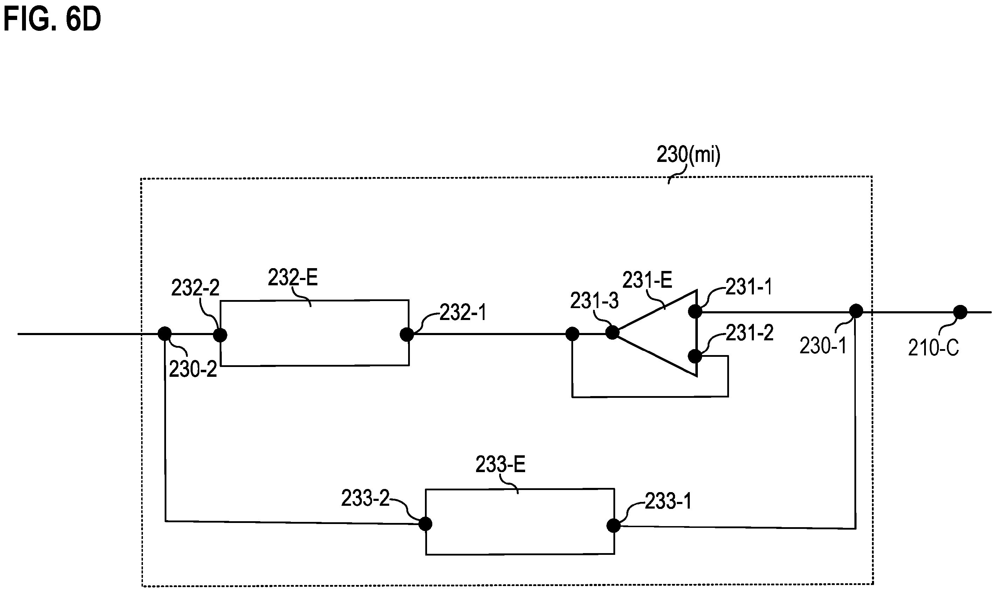

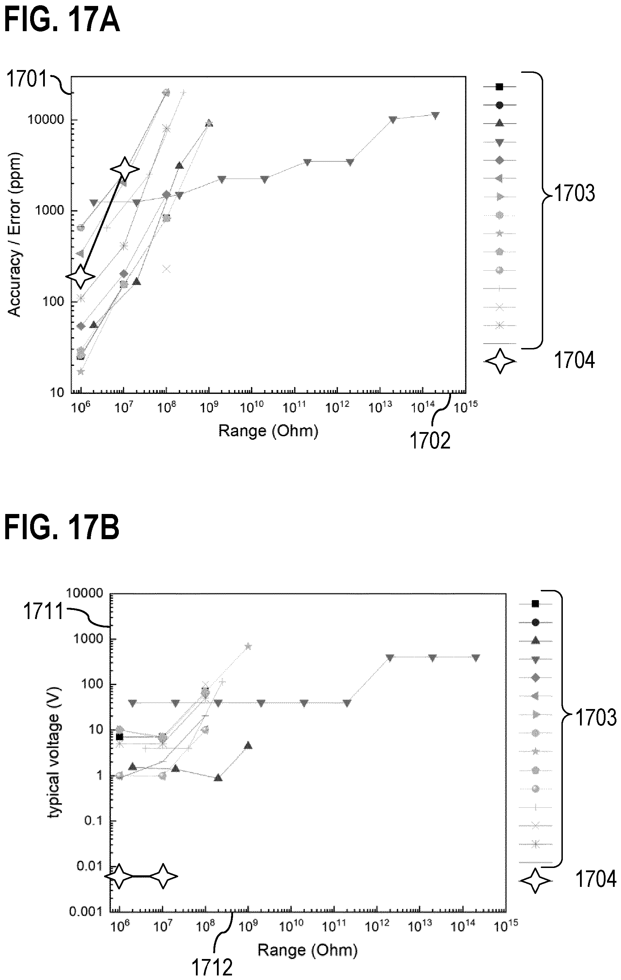

Fig.6D illustrates exemplarily a mirror-inverted first-type sub circuit 230(mi) according to various aspects that relates to an electrical system. The mirror-inverted first-type sub circuit 230(mi) shown in **Fig.6D** may be analogue to the first-type sub circuit 230 shown in Fig.6B but mirrored. In the mirrored first-type sub circuit 230(mi), the first-type sub circuit input node 230-1 is connected to the interconnect injection node 210-C of the at least three injection nodes 210. An exemplary mirrored first-type sub circuit 230(mi) included in a measurement device 100 according to various aspects is shown in Fig.17B.

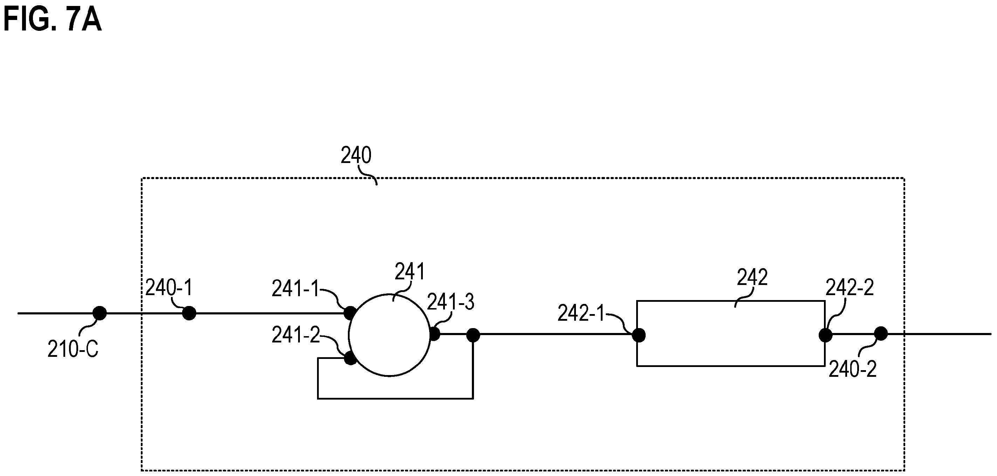

**Fig.7A** depicts a second-type sub circuit 240 according to various aspects. According to various aspects, the second-type sub circuit 240 may include a second active element 241 and a third sub-circuit probe-element 241. The second active element 241 and the third sub-circuit probe-element 241 may be connected in series.

According to various aspects the second active element 241 may be an active element as described herein. The second active element 241 may include a first input terminal 241-1, a second input terminal 241-2, and an output terminal 241-3. The second input terminal 241-2 and the output terminal 241-3 of the second active element 241 may be directly connected to each other. With other words, the output of the second active element 241 may act as one input of the same. Furthermore, the second active element 241 may be connected to a power supply (not shown) configured to supply the second active element 241 with power.

According to various aspects the third sub-circuit probe element 242 may be a probe element as described herein. Briefly, it may be a passive element that type may be based on the system and that may be described by its known characteristic property. For example, in an electric system, the third sub-circuit probe-element 242 may be an electric resistor, an electric inductor, or an electric capacitor, as described above.

According to various aspects, the characteristic property of the third sub-circuit probe-element 242 may be the same as the characteristic property first probe-element 106 of the measurement device 100, such as both may be resistances (e.g., electric, thermal, hydraulic) or capacitances, as examples. For example, the characteristic property of the third sub-circuit probe-element 242 may differ less than 25%, e.g., less than 10%, less than 5%, less than 1%, less than 0,1% from the characteristic property first probe-element 106 of the measurement device 100. A lesser difference between the characteristic properties of the third sub-circuit probe-element 242 and the characteristic properties of the first probe-element 106 may lead to a more effective measurement, e.g., a lesser difference may simplify the non-Hermitian matrix, describing properties of the measurement device.

According to various aspects the third sub-circuit probe-element 242 may include an input terminal 242-1 and an output terminal 242-2. The input terminal 242-1 of the third sub-circuit probe-element 242 may be connected to the output terminal 241-2 of the second active element 241.

For example, the second-type sub circuit 240 may include an input node, referred to as second-type sub circuit input node 240-1, and an output node, referred to as second-type sub circuit output node 240-2. The second-type sub circuit input node 240-1 may represent an input to the second-type sub circuit 240.

The second-type sub circuit input node 240-1 may be connected to the interconnect injection node 210-C of the at least three injection nodes 210. Furthermore, the second-type sub circuit input node 240-1 may be connected to the second active element 241. For example, the second-type sub circuit input node 240-1 may be connected to the input terminal 241-1 of the second active element 241.

The second-type sub circuit output node 240-2 may be connected to one of the at least three injection nodes 210. It should be understood that the injection node, to that the second-type sub circuit output node 240-2 is connected to, is different from the injection node to that the first-type sub circuit input node 230-1 is connected to. Furthermore, the second-type sub circuit output node 240-2 may be connected to the third sub-circuit probe element 242. For example, the second-type sub circuit output node 240-2 may be connected to the output terminal 242-2 of the third sub-circuit probe element 242.

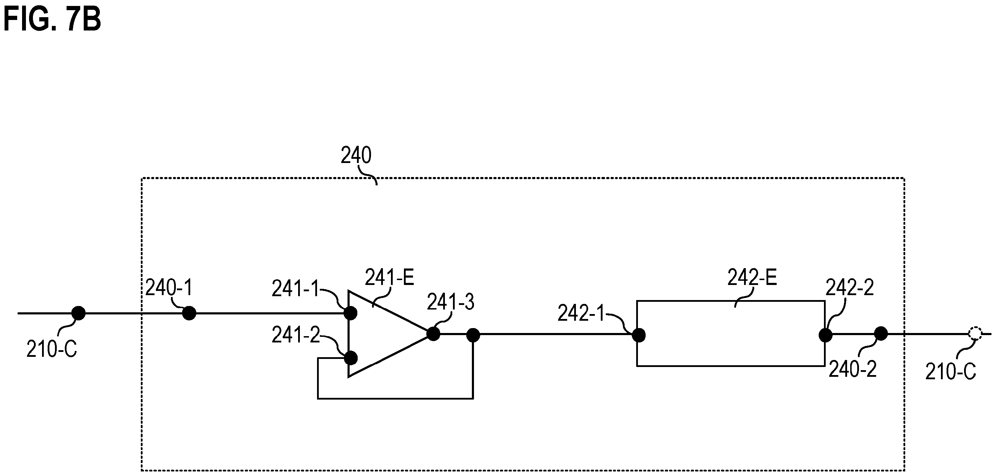

**Fig.7B** illustrates exemplarily a second-type sub circuit 240 according to various aspects that relates to an electrical system. For example, the third sub-circuit probe element 242 shown in Fig.7A may be an electric probe element, i.e., a third sub-circuit electric probe element 242-E, such as an electric resistor, an electric capacitor, or an electric inductor. Additionally, the second active element 241 may be an electric operational amplifier, i.e. a second electric operational amplifier 241-E. The other features described above with respect to the second-type sub circuit 240 in general pertain mutatis mutandis to the second-type sub circuit 240 relating to an electrical system.

According to various aspects the second active element 241 the second-type sub circuit 240 is an asymmetric circuit that causes a preferred direction in which the second-type sub circuit 240 may be passed.

This direction may be altered, by mirroring the second-type sub circuit 240. For example, the second-type sub circuit 240 may be mirrored that may be also referred to as mirror-inverted by rotating the second-type sub circuit 240 about 180°. However, the injection nodes of the at least three injection nodes, which are connected to the second-type sub circuit 240 may remain at their position. As a consequence, an injection node of the at least three injection nodes, which was connected to the second-type sub circuit output node before the mirroring, will be connected to the second-type sub circuit input node after the mirroring and vice versa.

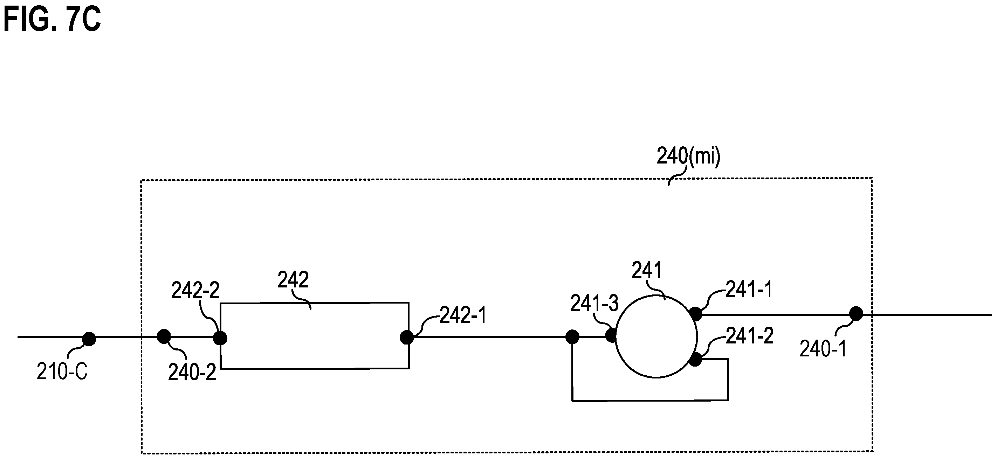

**Fig.7C** shows a mirror-inverted second-type sub circuit 240(mi) according to various aspects. As a consequence, the second-type sub circuit input node 240-1 may not be connected to the interconnect injection node 210-C of the at least three injection nodes. Instead, the second-type sub circuit output node 240-2 may be connected to the interconnect injection node 210-C of the at least three injection nodes.

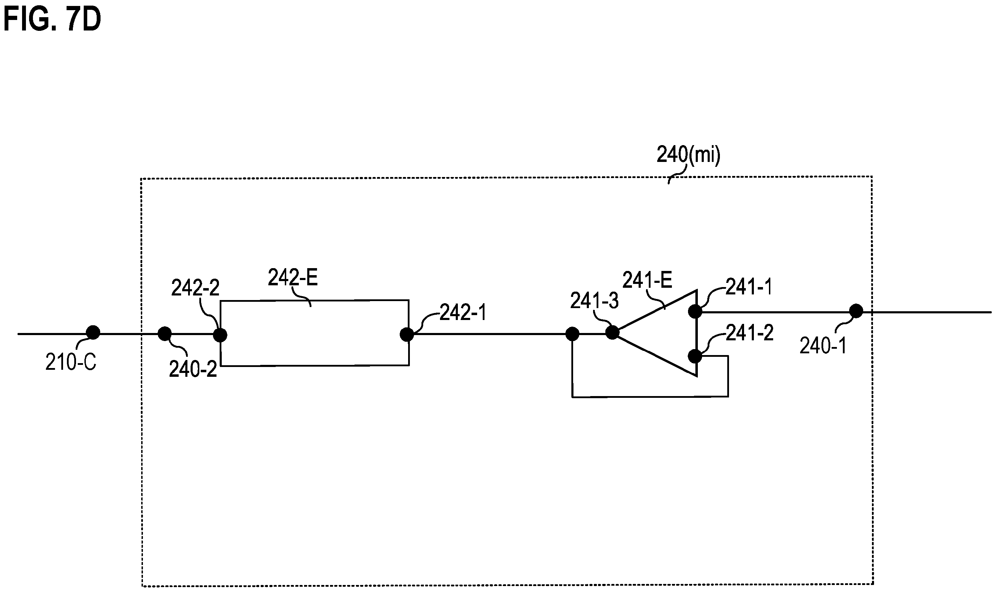

Fig.7D illustrates exemplarily a mirror-inverted second-type sub circuit 240(mi) according to various aspects that relates to an electrical system. The mirror-inverted second-type sub circuit 240(mi) shown in **Fig.7D** may be analogue to the second-type sub circuit 240 shown in Fig.7B but mirrored. In the mirrored second-type sub circuit 240(mi), the second-type sub circuit output node 240-2 is connected to the interconnect injection node 210-C of the at least three injection nodes 210. An exemplary mirrored second-type sub circuit 240(mi) included in a measurement device 100 according to various aspects is shown in Fig.17B.

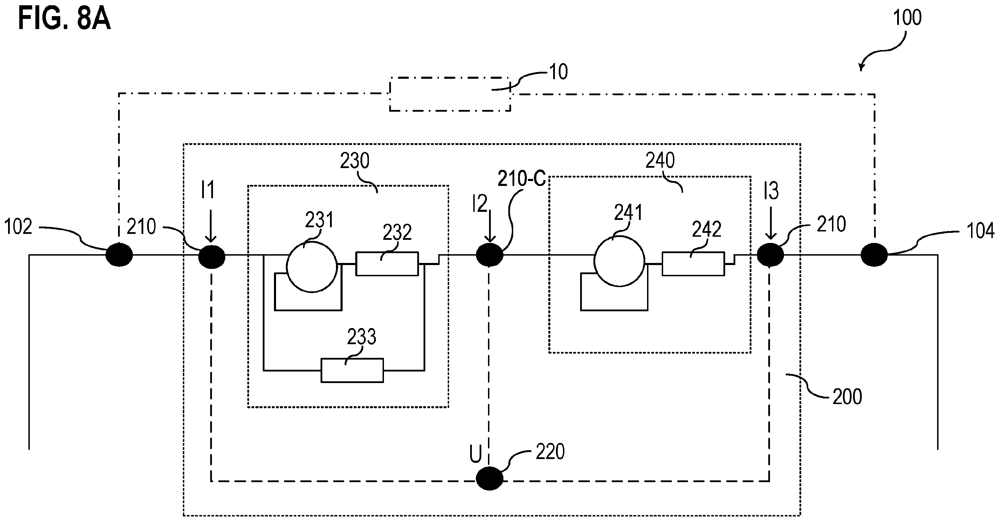

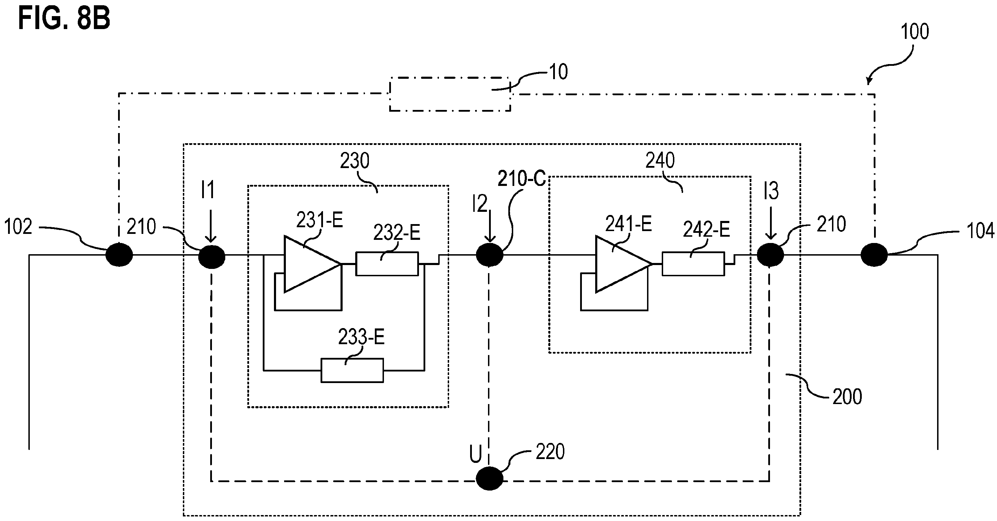

**Fig.8A** depicts a measurement device 100 including a measurement circuit 200 according to various aspects. Furthermore, Fig.8 depicts exemplary implementations of a first-type sub circuit 230 and a second-type sub circuit 240.

The first-type sub circuit 230 may be implemented as described above, including a first active element 231, a first sub circuit probe element 232, and a second sub circuit probe element 233. For example, the first-type sub circuit 230 may be implemented as shown in Fig.6A, whereby the nodes and terminals within the first-type sub circuit 230 are not shown to facilitate the illustration of the first-type sub circuit 230.

The second-type sub circuit 240 may be implemented as described above, including a second active element 241 and a third sub circuit probe element 242. For example, the second-type sub circuit 240 may be implemented as shown in Fig.7A, whereby the nodes and terminals within the second-type sub circuit 240 are not shown to facilitate the illustration of the second-type sub circuit 240.

**Fig.8B** illustrates exemplarily the measurement device 100 shown in Fig.8A for an electric system. For example, the first-type sub circuit 230 may be implemented as described above with respect to Fig.6B and the second-type sub circuit 240 may be implemented as described above with respect to Fig.7B.

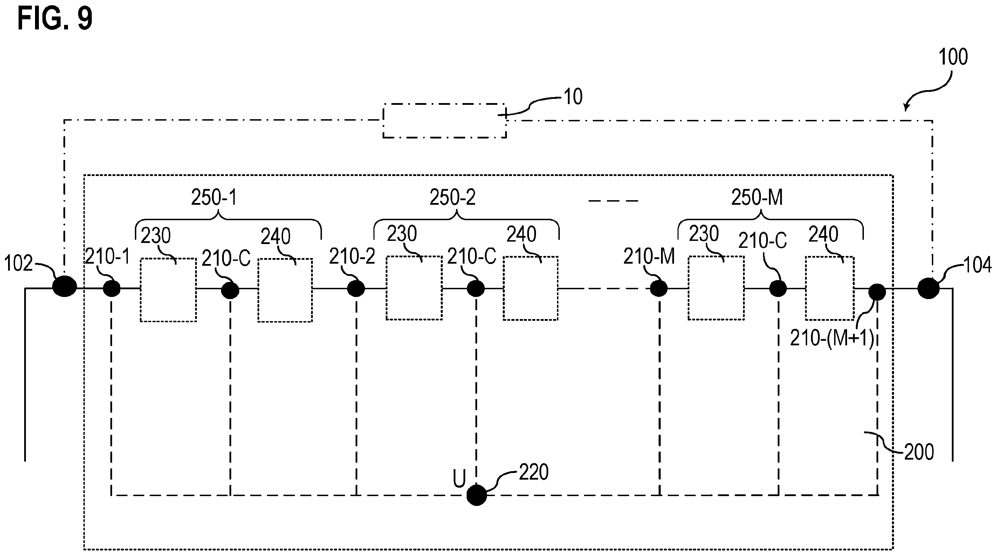

**Fig.9** depicts a measurement device 100 including a measurement circuit 200 according to various aspects. The measurement circuit 200 may include multiple first-type sub circuits 230 and multiple second-type sub circuits 240. According to various aspects, the multiple first-type sub circuits 230 and the multiple second-type sub circuits 240 form multiple sub circuit rows 250-(1, ..., M). Each of the multiple sub circuit rows 250-(1, ..., M) may include one of the multiple first-type sub circuits 230 and one of the multiple second-type sub circuits 240 that are connected by one interconnect node 210-C, i.e., one injection node of the at least three injection nodes 210. The multiple sub circuit rows 250-(1, ..., M) may be connected in series, wherein two adjacent sub circuits are connected via an injection node 210 of the at least three injection nodes 210. Illustratively, the multiple sub circuit rows 250-(1, ..., M) form a row of sub circuit rows. The first sub circuit row 250-1 and the last sub circuit row 250-M of the multiple sub circuit rows 250-(1, ..., M) may be connected to an additional injection node of the at least three injection nodes. Each of the multiple first-type sub circuits 230 may be arranged like a first-type sub circuits 230 described herein, e.g., with reference to Fig.6A, or Fig.6B. Each of the multiple second-type sub circuits 240 may be arranged like a second-type sub circuits 240 described herein, e.g., with reference to Fig.7A or Fig.7B.

Illustratively, Fig.9 depicts M sub circuit rows 250-(1, ..., M), wherein M is a natural number greater than 0, (e.g., 1, 2, 3, 4, 5, 6, 7, 8, 9, 10, 11, as examples) each including: one of the multiple first-type sub circuits 230, one interconnection node 210-C of the at least three injection nodes 210, and one of the multiple second-type sub circuits 240. Additionally, the measurement circuit 200 includes M+1 additional injection nodes 210-(1, ..., M+1) (i.e., a first additional node 210-1, a second additional node 210-2, ..., a M+1 additional node) of the at least three injection nodes 210. A first injection node 210-1 of the additional injection nodes 210-(1,...,M+1) may be connected to the first measurement node 102 and to a first sub circuit row 250-1. A last injection node 210-(M+1) of the additional injection nodes 210-(1,...,M+1) may be connected to the last sub circuit row 250-M and to the second measurement node 104. In total, the measurement circuit 200 may include 2M+1 injection nodes 210, M first-type sub circuits 230 and M second-type sub circuits 240. Hence, the measurement device 100 includes an odd number of injection nodes 210 greater than 2, e.g., a prime number of injection nodes 210.

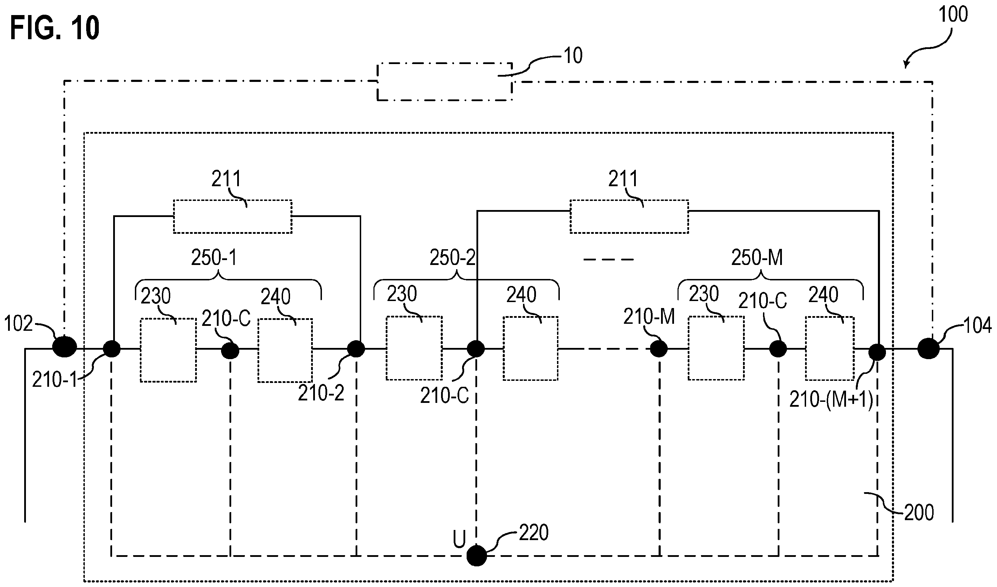

**Fig.10** depicts a measurement device 100 including a measurement circuit 200 according to various aspects. Like already shown in Fig.9, the measurement circuit 200 may include M first-type sub circuits 230, M second-type sub circuits 240 and (2M+1) injection nodes of the at least three injection nodes 210, wherein 2M+1 may be also referred to as N, i.e., N=2M+1. The M first-type sub circuits 230, the M second-type sub circuits 240 and the M of the (2M+1) injection nodes (also referred to as interconnect nodes 210-C) of the at least three injection nodes 210 may form together M sub circuit rows 250. The M sub circuit rows 250 may form a row of sub circuit rows 250, wherein two adjacent sub circuit rows 250 of the M sub circuit rows 250 are connected to each other by an injection node of the remaining M+1 injection nodes of the at least three injection nodes 210. Furthermore, as shown in Fig.10 the remaining M+1 injection nodes of the at least three injection nodes 210 may be connected to each other by a parallel connection 211 to one or more sub circuit rows 250.

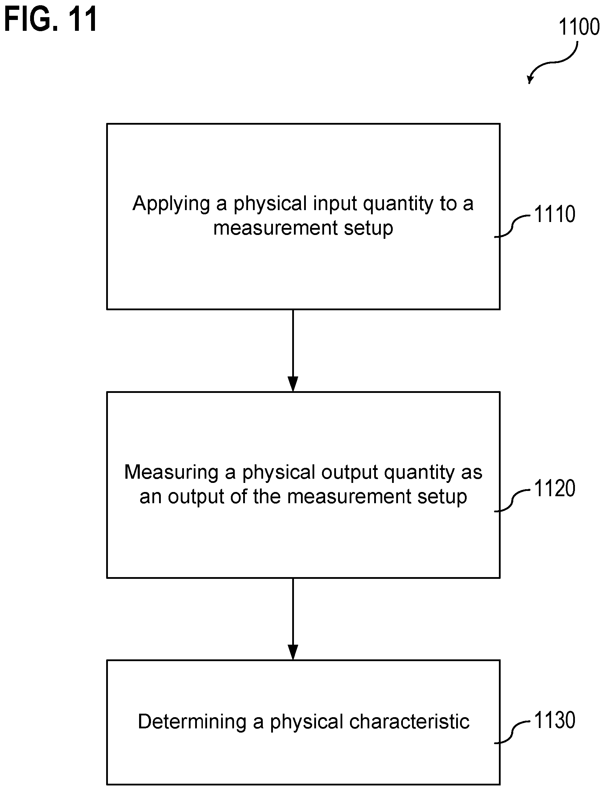

Fig.11 depicts a method 1100 for determining a physical characteristic and/or a variation of the physical characteristic of a device to be tested according to various aspects. For example, the physical characteristic to be determined may be correlated to a physical input quantity and a physical output quantity. The method 1100 may be performed using a measurement setup that represents the correlation between the physical input quantity, the physical output quantity and the physical characteristic to be determined via a non-Hermitian Matrix. Furthermore, the measurement setup may include at least three input nodes (e.g., an odd number of input nodes greater than 1) for providing the physical input quantity as an input vector. The method 1100 may include applying S1110 the physical input quantity as an input vector to the at least three input nodes of the measurement setup.

For example, values of the input vector of the first physical characteristic may be proportional to the values of an eigenvector of the non-Hermitian Matrix. For example, according to various aspects the values of the input vector of the first physical characteristic may differ from values being proportional to an eigenvector of the non-Hermitian Matrix, e.g., by less than 20%, e.g., by less than 10%, e.g., by less than 5%. For example, the Euclidean norm of the difference between the injected vector and an eigenvector may be less than 20%, e.g., may be less than 10%, e.g., may be less than 5%. of the Euclidean norm of the eigenvector.

The method 1100 may further include measuring S1120 the physical output quantity as an output vector of the measurement setup. The output quantity may be proportional to the input vector. Additionally, the output quantity may be proportional to at least one eigenvalue of the non-Hermitian Matrix. In another example, the output quantity may differ from values being proportional to an eigenvector of the non-Hermitian Matrix, e.g., by less than 20%, e.g., by less than 10%, e.g., by less than 5%. For example, the Euclidean norm of the difference between the output quantity, which may be formulated as an output vector, and an eigenvector may be less than 20%, e.g., may be less than 10%, e.g., may be less than 5%. of the Euclidean norm of the eigenvector.

The method 1100 may further include determining S1130 the physical characteristic to be determined. For example, the determining of the physical characteristic to be determined may be based on a correlation of the input vector, the eigenvalue of the non-Hermitian Matrix and the measured output vector. For example, the determining of the physical characteristic to be determined may be based on a comparison of a predetermined value and some component of the measured output vector.

In the following, various aspects relate to a measurement device that may be included in an electronic system or that may be connected to a measurement system. In some aspects, an electrical current injection may be utilized to operate the measurement device using, for example, a voltage controlled current injection. However, the current injection may be also realized by in a current controlled manner, mutatis mutandis.

One example of the embodiment according to various aspects may refer to a measurement device and a method that may allow to measure a targets' resistance by making use of one or more current sources. The one or more current sources may each inject a current into the device under test (e.g., simultaneously) into different nodes of an electronic measurement circuit. Hence, the different nodes of the electronic measurement circuit may be connected to different current sources and the voltage measured at the different nodes can be measured by voltmeters. The different nodes may form a chain in that the first and the last node of the different nodes may constitute an output of the measurement-device and may be connected to the device under test, e.g., a resistor. The voltage measured at some nodes of the different nodes, e.g., measured by voltmeters, may be related to the value of the resistance under test and realizes an indirect measurement of the resistance, e.g., after a calibration procedure.

According to various aspects it was identified, that for a linear system, the voltages and the currents applied or measured on the different nodes may be related by a conductance matrix. Furthermore, it was discovered, that, if the conductance matrix is non-Hermitian, it may show enhanced spectral sensitivity. In this case, the voltage (or current) on specific nodes may become extremely sensitive to the value of the resistance between the first and the last node onto that a device under test may be connected to. Therefore, those values may be a very relevant quantity for measuring a resistance or other electrical properties of the device under test that may be somehow related to the electric resistance. Furthermore, it was discovered, that a sensitivity to be expected regarding the measurement may depend exponentially onto a number of nodes, and subsequently onto a number of sources, e.g., voltage sources and or current sources.

According to various aspects it was further discovered that all injected currents that may be described as an injected current vector (ICV), and all measured voltages that may be described as a measured-voltage-vector (MVV), may be related to each other by the conductance matrix. Moreover, it was discovered that, when the input currents are chosen such that the ICV represents an eigenvector of the conductance matrix, the MW will be proportional to the ICV, wherein a proportionality constant is given by an eigenvalue of the conductance matrix. Furthermore, it was discovered that, when the target resistance changes, the eigenvalue is modified by a factor that is exponential in the number of current sources, thus resulting in an enhanced sensitivity. Illustratively, there may be a large shift in measured voltages for a relatively small change of the target resistance but whereby the input currents are kept constant.

Hence, one example of a measurement device according to various aspects, amongst other benefits, may allow for high sensitivity regarding the measurement of the characteristic electric property of the device to be analyzed. In more detail the sensitivity of the measurement device may increase with respect to an amount of current injection nodes and/or with respect to a number of active elements that are included in the measurement circuit. With other words, a number of current sources and/or a number of active elements may increase a sensitivity of the measurement device. Furthermore, it may be possible using the measurement device according to various aspects to do reliable measurements of devices having a comparable high electric resistance (e.g., more than 100 000 Ohm) using low voltages (e.g., less than 1 000 V) and/or low currents (e.g., less than 100 nA) that may be beneficial for measuring sensitive devices.

In a conventional ohmmeter, the current and the voltage may be proportional to each other having a proportionality constant equal to a value representing the resistance R. The measurement device according to various aspects allows to increase the proportionality constant above the resistance R. As a consequence, this may lead to an enhanced sensitivity of a measurement. Furthermore, this may allow to realize an indirect measurement such that an equivalent impedance of the device to be tested for each node is strongly reduced with respect to the target resistor thereby allowing more sensitive measurements. Subsequently, a sensitivity of a sensor based on the measurement circuit may improve exponentially with the number of current sources. Illustratively the high sensitivity is a result of the spectral sensitivity of the non-Hermitian conductance matrix that is a very robust property of such systems. As an example, the non-Hermitian conductance matrix may be insensitive to the exact values of the resistances.

According to various aspects a measurement device is provided that may be used to do an indirect measurement of an electrical resistance. It was discovered that an input-impedance, which may influence (e.g., may be measured by) a voltmeter may be smaller than a target impedance itself. Therefore, the measurement device according to various aspects may allow for a measurement having a sensitivity that does drop less compared to a sensitivity of a conventional measurement device, especially if an electrical resistance is more than about 1 MOhm. Subsequently, the measurement device according to various aspects may be used as a megaohmmeter and/or as an insulation tester. An insulation tester may be a testing device to test if an electric resistance of an insulator is high enough to fulfill its specifications.

According to various aspects it was further discovered that a total impedance of each node may not directly related to the resistance of the device under test and may be orders of magnitudes lower (e.g., hundreds of kOhm (kOhm = kilo Ohm = 1000 Ohm). This may for example allow for the use of one or more standard voltage measurement devices having a reasonable input impedance and the use of such voltmeter in a reasonable (e.g., a highest) sensitivity range.

According to various aspects an electronic circuit fulfilling the abovementioned criteria may include electronic devices like resistors and operational amplifiers, working at room temperature or at very low temperature regimes.

According to various aspects, the measurement device may also be adapted to some on-chip measurements at very low temperature and/or under a magnetic field, with no use of active elements.

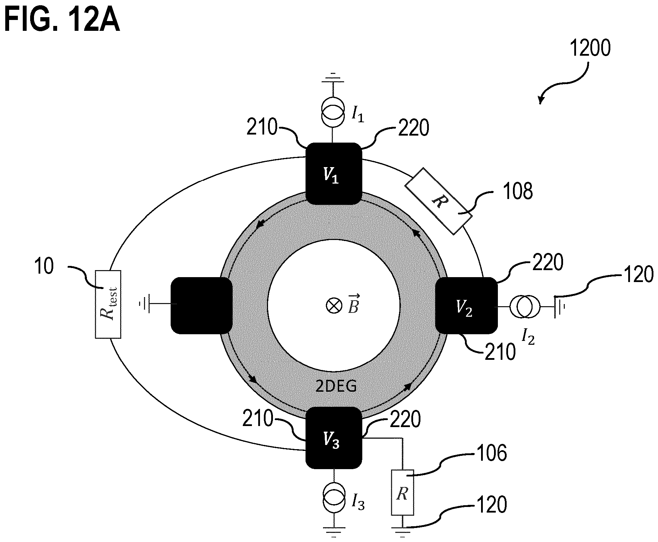

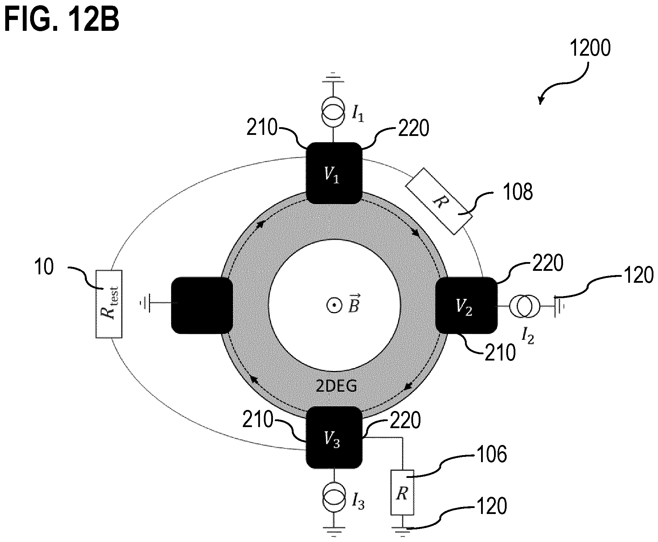

One example of measurement device according to various aspects refers to a set of contacts of an electric circuit may be connected to a mesoscopic system in the quantum Hall effect regime. An exemplary electronic circuit including the quantum Hall system and multiple electronic elements is shown in **Fig.12.** The electronic circuit may be described using a non-Hermitian conductance matrix that presents highly sensitive eigenvector components to the target resistance.

For example, at liquid helium temperature, when a large magnetic field is applied perpendicular to a high mobility two-dimensional electron gas (2DEG) of a reasonably low density, bulk transport may vanish in the 2DEG, and transport may occur along edge channels (the quantum Hall effect regime). These channels may be chiral so that charge transport from left to right happens on one side of the device whereas charge transport from right to left takes place at the opposite edge of the 2DEG. Moreover, transport in edge channels may be purely ballistic in a sense that a quasi-particle of an edge channel cannot be backscattered unless the channel is coupled to the opposite channel. Finally, the edge channels may be constituted by a finite number of purely one-dimensional conducting channel. The number of edge channel is called the filling factor v and in a two-points configuration, the resistance associated to a 2DEG device in the quantum Hall effect is universal and given by $h/(e^2\,v)$: it may be a topological quantity that becomes roughly independent on the geometry, mobility or any other microscopic parameter.

A linear electronic system with multiple sources may be defined as a system for that the response to an excitation (eventually multisource excitation) is proportional to the excitation. In this case, the system may be generally described by a conductance or a resistance matrices G and R wherein G=R$^{-1}$. Defining a current vector $\vec{I}$ as a vector that components may correspond to all the current sources injected in active contacts of the system (e.g., at a site) and a voltage vector $\vec{U}$ as a vector that components may correspond the voltage of each active contact, the resistance matrix is such that $\vec{U}=R\vec{I}$ and the conductance matrix $\vec{I}=G\vec{U}$ where R and G can be predicted using Kirchhoff's laws on each active sites.

According to various aspects it was discovered, that measuring the R matrix of such a linear system in the Quantum Hall Effect (QHE) regime may lead to some non-Hermitian G matrix due to the chirality of the current. As mentioned above, such a system may show a spectral sensitivity that can be used to detect very large resistance with high precision.

**FIG.12** illustrates an exemplarily quantum Hall system that is herein also referred to as a multisource QHE-based device 1200. The multisource QHE-based device 1200 may include three injection nodes 210, onto that three active contacts, e.g., three sites, V1, V2, and V3 are connected to. Furthermore, each of the three injection nodes 210 may be coupled to one sensing node 220 (e.g., are formed as single contact). The circuit further includes a first (electrical) probe element 106 and a second (electrical) probe element 108 that are in this example a first resistor and a second resistor. Furthermore, the multisource QHE-based device 1200 may include a device to be analyzed 10 that is connected to a first of the three injection nodes 210 (V1) and to a third of the three injection nodes 210 (V3).

The multisource QHE-based device 1200 includes a ring that is a high mobility 2DEG etched in a GaAs heterostructure. A magnetic field $\vec{B}$ may be applied perpendicular to the ring may be about 5.5 T and the temperature may be about 2 K.

By applying a current vector close to an eigenvector of the R or G matrix without any test resistor, voltages may be measured on the three sites that amplitude changes when $R_{test}$ changes. For the current sources choose, the contact V2 may show a very high sensitivity with respect to $R_{test}$. Hence, by varying the resistance $R_{test}$ between 1MOhm $\pm$10%, an error may be evidenced, regarding a conventional resistance-measurement device of about 570 Ohm, whereas the measurement using a set-up according to Fig.12A and standard lock-in amplifiers may lead to a precision of about 210 Ohm.

In another example, the same multisource QHE-based device 1200 may be configures as a 5 sites set-up (instead of three), whereby a measurement precision may be raised to about 150 Ohm. Importantly, the voltage applied on the test resistor is about three orders of magnitude lower than for the conventional resistance-measurement device.

In another example, a similar R or G matrix may be obtained in an electronic circuit including operational electronic amplifiers at room temperature and without magnetic fields. An exemplary measurement device using voltages may be used to measure $R_{test}$ of about 1 MOhm in a range of $\pm$10% to a precision of about 45 Ohm using the three sites room temperature electronic setup up and using standard lock-in amplifiers, whereas a conventional resistance-measurement device could only reach a precision of about 800 Ohm. Furthermore, the voltage applied on the device under test including $R_{test}$ was about 50 times lower than for the conventional resistance-measurement device.

Fig.12B shows a measurement set-up that corresponds to the measurement set-up of Fig.12A, but the direction of the magnetic field B may be inverted. By inverting the direction of the magnetic field B, a direction of an induced current may change, too. The change of the current direction is illustrated by the changed arrow direction.

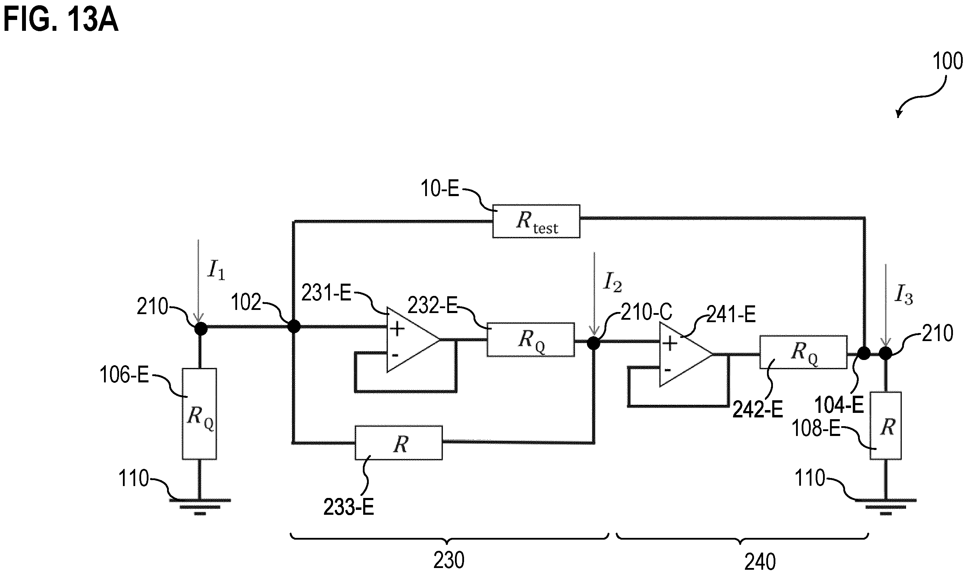

In another example the measurement device 100 may be realized as a measurement device 100 for an electric system including multiple operational electronic amplifiers and resistors that are arranged as explained above. In more detail, the measurement device 100 may include resistances labeled R and $R_Q$ that are shown in **Figures 13A** to **14B.** The exemplary measurement devices 100 of Figures 13A to 14B may be configured to measure an unknown resistance of an electronic device under test 10-E, labeled $R_{test}$. Therefore, a total of N currents ($I_1$,..., $I_N$) may be injected at N injection nodes 210 of the circuit, and a voltage difference with respect to ground is measured at N sensing nodes ($U_1$,..., $U_N$).

N is an odd number greater than 1, e.g., N=3,5,7, as examples. Using Kirchhoff's equations, the vector of injected

currents $\vec{I} = (I_1,..., I_N)$ may be related to the vector of measured voltages $\vec{U} = (U_1,..., U_N)$ using a conductance matrix that may be a function of $R_{test}$, in detail $\vec{I} = G(R_{test})\vec{U}$.

In one example, N may be three, N = 3.

A first exemplary measurement device 100 for N = 3 according to various aspects for an electronic system is shown in Fig.13A. It may be seen that the first exemplary measurement device 100 for N = 3 may include a first type sub-circuit corresponding to Fig. 6B and a second sub-circuit corresponding to Fig.7B. Furthermore, a first electric probe element 106-E may be connected to a first measurement node 102 and a second electric probe element 108-E may be connected to a second node measurement node 104. The conductance matrices $G_3$ of the first exemplary measurement device 100 for N = 3 may take the form:

$$G_3 = \begin{pmatrix} \dfrac{1}{R_Q} + \dfrac{1}{R} + \dfrac{1}{R_{test}} & -\dfrac{1}{R} & -\dfrac{1}{R_{test}} \\[2ex] -\dfrac{1}{R_Q} - \dfrac{1}{R} & \dfrac{1}{R_Q} + \dfrac{1}{R} & 0 \\[2ex] -\dfrac{1}{R_{test}} & -\dfrac{1}{R_Q} & \dfrac{1}{R_Q} + \dfrac{1}{R} + \dfrac{1}{R_{test}} \end{pmatrix}$$

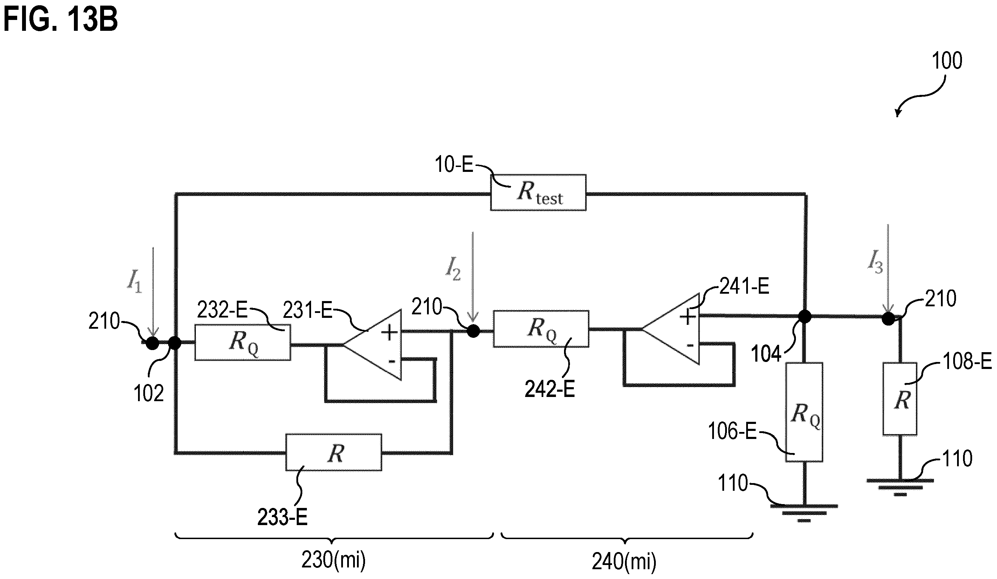

A second exemplary measurement device 100 for N = 3 according to various aspects for an electronic system is shown in Fig.13B. In contrast to the first exemplary measurement device 100, the second exemplary measurement device 100 may include a mirror-inverted first-type sub circuits 230(mi) and a mirror-inverted second-type sub circuits 240(mi), as explained with respect to Figures 6C, 6D, 7C and 7D. Briefly, the mirror inverted sub circuit may be rotated by 180° compared to the corresponding sub circuit that is not mirrored. Because of the mirroring, a preferred current flow direction through the measurement device may be altered. Furthermore, a first electric probe element 106-E and a second electric probe element 108-E may be connected to the same node, e.g., the second measurement node 104. The conductance matrices $G_3^{mi}$ of the second exemplary measurement device 100 for N = 3 may take the form:

$$G_3^{mi} = \begin{pmatrix} \dfrac{1}{R_Q} + \dfrac{1}{R} + \dfrac{1}{R_{test}} & -\left(\dfrac{1}{R_Q} + \dfrac{1}{R}\right) & -\dfrac{1}{R_{test}} \\[2ex] -\dfrac{1}{R} & \dfrac{1}{R_Q} + \dfrac{1}{R} & -\dfrac{1}{R_Q} \\[2ex] -\dfrac{1}{R_{test}} & 0 & \dfrac{1}{R_Q} + \dfrac{1}{R} + \dfrac{1}{R_{test}} \end{pmatrix}$$

In another example, N may be five, N = 5.

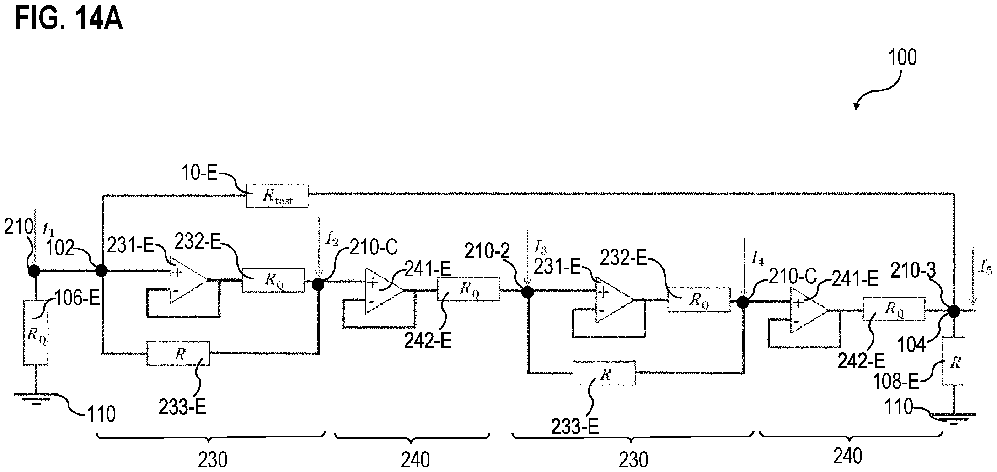

A first exemplary measurement device 100 for N = 5 according to various aspects for an electronic system is shown in Fig.14A. It may be seen that the first exemplary measurement device 100 for N = 5 may include multiple first type sub-circuits each corresponding to Fig. 6B and multiple second sub-circuits each corresponding to Fig.7B. The conductance matrices $G_5$ of the first exemplary measurement device 100 for N = 5 may take the form:

$$G_5 = \begin{pmatrix} \frac{1}{R_Q}+\frac{1}{R}+\frac{1}{R_{test}} & -\frac{1}{R} & 0 & 0 & -\frac{1}{R_{test}} \\ -\frac{1}{R_Q}-\frac{1}{R} & \frac{1}{R_Q}+\frac{1}{R} & 0 & 0 & 0 \\ 0 & -\frac{1}{R_Q} & \frac{1}{R_Q}+\frac{1}{R} & -\frac{1}{R} & 0 \\ 0 & 0 & 0 & \frac{1}{R_Q}+\frac{1}{R} & 0 \\ -\frac{1}{R_{test}} & 0 & 0 & -\frac{1}{R_Q} & \frac{1}{R_Q}+\frac{1}{R}+\frac{1}{R_{test}} \end{pmatrix}$$

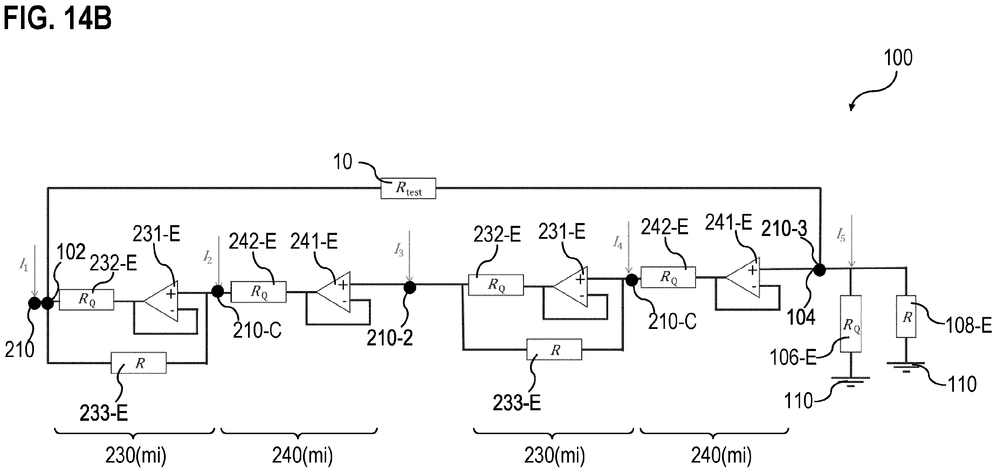

A second exemplary measurement device 100 for N = 5 according to various aspects for an electronic system is shown in Fig.14B. In contrast to the first exemplary measurement device 100, the second exemplary measurement device 100 may include multiple mirror-inverted first-type sub circuits 230(mi) and multiple mirror-inverted second-type sub circuits 240(mi), as explained with respect to Figures 6C, 6D, 7C and 7D. As in Fig.13B, due to the mirroring, a preferred current flow direction through the measurement device may be altered. As in the second exemplary measurement device 100 for N = 3, the first electric probe element 106-E and the second electric probe element 108-E may be connected to the same node, e.g., the second measurement node 104. The conductance matrices $G_5^{mi}$ of the second exemplary measurement device 100 for N = 5 may take the form:

$$G_5^{mi} = \begin{pmatrix} \frac{1}{R_Q}+\frac{1}{R}+\frac{1}{R_{test}} & -\left(\frac{1}{R_Q}+\frac{1}{R}\right) & 0 & 0 & -\frac{1}{R_{test}} \\ -\frac{1}{R} & \frac{1}{R_Q}+\frac{1}{R} & -\frac{1}{R_Q} & 0 & 0 \\ 0 & 0 & \frac{1}{R_Q}+\frac{1}{R} & -\left(\frac{1}{R_Q}+\frac{1}{R}\right) & 0 \\ 0 & 0 & -\frac{1}{R} & \frac{1}{R_Q}+\frac{1}{R} & -\frac{1}{R_Q} \\ -\frac{1}{R_{test}} & 0 & 0 & 0 & \frac{1}{R_Q}+\frac{1}{R}+\frac{1}{R_{test}} \end{pmatrix}$$

The conductance matrix may be diagonalized for $1/R_{test}$ = 0, $G\vec{\psi}_j = \lambda_j\vec{\psi}_j$, yielding N eigenvalues $\lambda_j$ and N eigenvectors $\vec{\psi}_j$. When the vector of input currents is chosen to be proportional to an eigenvector of the conductance matrix, $\vec{I} \propto \vec{\psi}_j$, then the measured voltage vector $\vec{U}$ may be proportional to the input current vector $\vec{I}$ multiplied by the corresponding eigenvalue $\lambda_j$: $\vec{U} \propto 1/\lambda_j\vec{\psi}_j$.

According to various aspects it was discovered that the eigenvalues of the conductance matrix corresponding to the measurement device 100 may be very sensitive to small changes in $1/R_{test}$. This sensitivity may occur due to the fact that the conductance matrix is non-Hermitian, e.g., the conductance matrix may be real, and not symmetric. In contrast, for a circuit in that the conductance matrix is Hermitian, i.e., real, and symmetric, all eigenvalues of G may change by an amount of the same order as $1/R_{test}$.

As a first step, the measurement device 100 may be initialized without the device under test and its corresponding test resistance $R_{test}$ attached thereto. Accordingly, the values of $1/R_{test}$ are set to 0 in the Matrix G, e.g., in $G_3$, $G_3^{mi}$, $G_5$ and/or $G_5^{mi}$ as shown above. Furthermore, for any odd value of N > 3 one of the eigenvalues of the Matrix G will be equal to $\lambda_0 = 1/R + 1/R_Q$. The measurement device 100 may be initialized by choosing input currents proportional to the corresponding G matrix eigenvector, $\vec{I} \propto \vec{\psi}_0$. As such, the measured voltages may be $\vec{U} \propto 1/\lambda_0\vec{\psi}_0$.

After the initialization is done, a device under test 10 having a large test resistance $R_{test}$ may be connected to the measurement device 100, as shown in Figures 13 and 14. This may cause a shift in the eigenvalue of Matrix G: $\Delta\lambda_0$ and

therefore a shift in the measured voltage: $\Delta\vec{U} \propto \Delta\lambda_0/\lambda_0{}^2\vec{\psi_0}$.

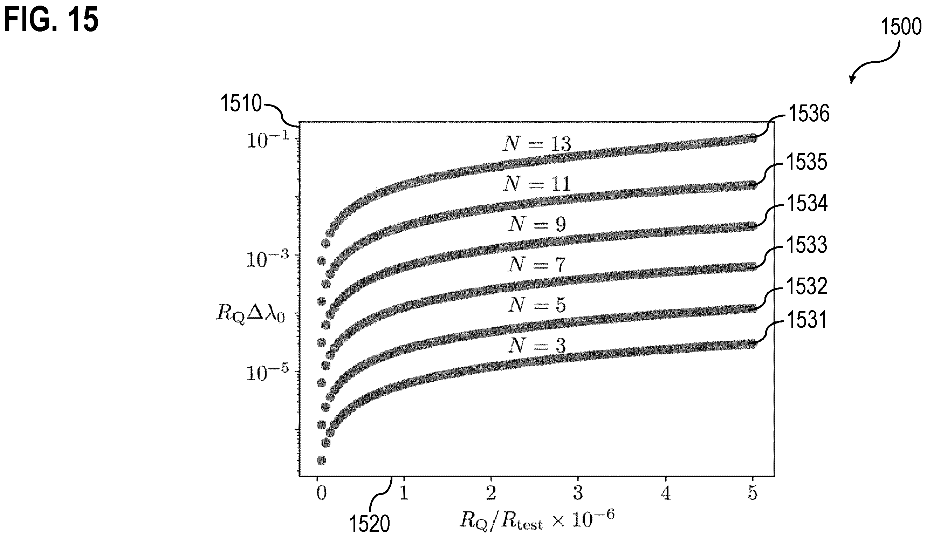

**Fig.15** illustrates a diagram showing the change of eigenvalue $R_Q\Delta\lambda_0$ as a function of $R_Q/R_{test}$, whereby R was set to $5R_Q$. Furthermore, in the following, the physical quantities may be expressed relative to the resistance $R_Q$. The vertical axis 1510 represents the eigenvalue $R_Q\Delta\lambda_0$ of the Matrix G. The horizontal axis 1520 represents the quotient of $R_Q/R_{test} \cdot 10^{-6}$. Within the diagram, different eigenvalues $R_Q\Delta\lambda_0$ are shown as function of $R_Q/R_{test}$ as curves 1531 to 1536, whereby each curve is corresponding to one exemplary number N of injection nodes, e.g., 1531 to N=3, 1532 to N=5, 1533 to N=7, ..., 1536 to N=13. The measurements were performed using the inverted sub-circuits, i.e., a measurement for N=3 was performed using the second exemplary measurement device 100 for N=3 as depicted in Fig.13B and a measurement for N=5 was performed using the second exemplary measurement device 100 for N=3 as depicted in Fig.13B. For greater N, i.e., N>5, a corresponding exemplary measurement device 100 may obtained by a person skilled in the applying the information given herein, e.g., with respect to Figures 10, 6B, 6D, 7B, 7D, and 13A-14B.

**Fig.15** illustrates a diagram showing the change of eigenvalue $R_Q\Delta\lambda_0$ as a function of $R_Q/R_{test}$, whereby R was set to $5R_Q$. Furthermore, in the following, the physical quantities may be expressed relative to the resistance $R_Q$. The vertical axis 1510 represents the eigenvalue $R_Q\Delta\lambda_0$ of the Matrix G. The horizontal axis 1520 represents the quotient of $R_Q/R_{test} \cdot 10^{-6}$. Within the diagram, different eigenvalues $R_Q\Delta\lambda_0$ are shown as function of $R_Q/R_{test}$ as curves 1531 to 1536, whereby each curve is corresponding to one exemplary number N of injection nodes, e.g., 1531 to N=3, 1532 to N=5, 1533 to N=7, ..., 1536 to N=13.. The measurements were performed using a measurement device including mirror-inverted first-type sub circuits 230(mi) and mirror-inverted second-type sub circuits 240(mi), i.e., a measurement for N=3 was performed using the second exemplary measurement device 100 for N=3 as depicted in Fig.13B and a measurement for N=5 was performed using the second exemplary measurement device 100 for N=5 as depicted in Fig.14B. For greater N, i.e., N>5, a corresponding exemplary measurement device 100 may obtained by a person skilled in the applying the information given herein, e.g., with respect to Figures 10, 6B, 6D, 7B, 7D, and 13A-14B.

Due to the non-Hermitian nature of the matrix G, the change in eigenvalue $R_Q\Delta\lambda_0$ (and therefore the change in measured voltage $\Delta\vec{U}$) may be in orders of magnitude greater than the change in the test resistance $R_{test}$. The curves 1531 to 1536, each corresponding to a different number of injection nodes, i.e., input currents, may be equally spaced from each other on a logarithmic scale, meaning that by increasing the number of input currents an exponential increase in sensitivity may be achieved. For example, if N = 13, then a change of the test resistance from $R_Q/R_{test} = 10^{-6}$ to $R_Q/R_{test} = 3 \cdot 10^{-6}$ may lead to a change in eigenvalue that is ten thousand times greater than from $R_Q\Delta\lambda_0 = 0.01$ to 0.05. This may provide a method and a device to accurately measure large resistances with $R_{test} \gg R_Q$.

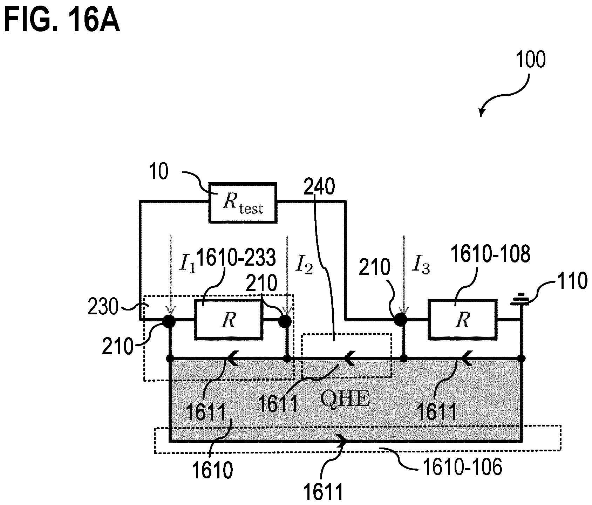

Another example refers to a quantum Hall System. According to various aspects it was discovered that a similar conductance matrix as stated with respect the previous examples may be obtained by replacing operational electronic amplifiers shown with the unidirectional edge modes of a quantum Hall System, as it is illustrated in **Fig.16A** for N=3. The measurement device 100 may be realized using a system 1610 in the quantum Hall effect regime, whereby the arrows 1611 denote the unidirectional conducting edge modes. The direction of the arrows may correspond to a direction of a magnetic field applied to the QHS, i.e., if the magnetic field is applied from another direction, the direction of the arrows may change. The conductance matrix of this measurement device 100 is similar to the conductance matrix $G_3$ shown above with respect to the previous example.

More precisely, compared to the measurement device 100 of Figures 4 and 5, the quantum Hall System 1610 may take over several roles of the measurement device 100. First, the QHS 1610 may act as a first resistor 1610-106 (i.e., a first probe element 106). Secondly, the QHS 1610 and a first resistor-element 1610-233 (i.e., a second sub-circuit probe-element 233) may act as a first-type sub circuit 230. Lastly, the QHS 1610 may act as a second-type sub circuit 240. A second resistor element 1610-108 may act as a second probe element 108.

The one-way conducting edge states of the quantum Hall system may lead to a resistance $R_Q = h/ve^2 \cong 25.8$ kOhm/v, wherein where $h$ is Planck's constant, $e$ is the electron charge, and $v$ is the number of edge modes of the quantum Hall system.

As explained above, the exemplary measurement device 100 may be adapted to measure other physical properties. In some examples, it was shown how to measure an electrical resistance.

Furthermore, the exemplary measurement device 100 may be adapted to measure other electrical properties like large inductances or small capacitances. This may be possible using one or more active elements at room temperature. To do such kind of measurements, each electric probe element, i.e., each depicted resistor illustrated in the Figures illustrating the electronic scheme may be replaced by capacitor to measure a capacitance or an inductor to measure an inductivity.

In order to have a direct equivalence between the resistance measurement and the inductance measurement, the value of the inductance should be chosen such that R=L $2\pi$f, wherein f is the AC frequency of the measurement. In order to have a direct equivalence between the resistance measurement and the capacitance measurement, the value of the capacitance should be chosen such that R=1/(C $2\pi$f), wherein f is the AC frequency of the measurement.

The conductance matrix G takes the same form for inductances and for capacitances as for resistances except a prefactor j for the conductance and -j for the inductance. In other words, the eigenvalues of the conductance matrix G will be dephased by a factor $\pm\pi/2$ and the voltages will be dephased accordingly with respect to the resistance case.

To measure other physical properties several examples were already provided above, e.g., for thermal systems, or for fluid systems, but further physical properties may be also measured by the person skilled in the art, as well, as long as the system may be described using a non-Hermitian Matrix in the way as explained above.

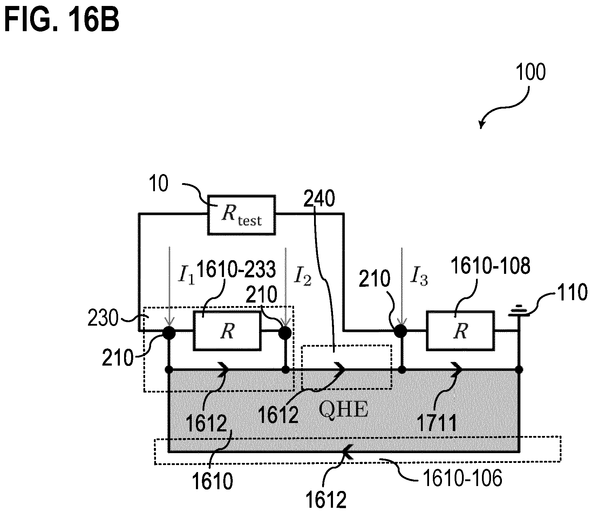

**In Fig.16B** another example of a measurement system 100 according to various aspects is shown. The measurement system 100 of Fig.16B is analogue to the measurement system 100 depicted in Fig.16A, but the magnetic field applied to the QHS is opposed. In more detail, the magnetic field is applied in an opposite direction compared to Fig.16A. As stated above, the current modes 1612 may change, which may lead to another direction of the corresponding arrows, as shown.

The change of the unidirectional conducting edge modes caused by the opposed magnetic field may also be represented in the measurement system 100 according to various aspects that may not be used outside a Quantum Hall System.

Figures 17A and 17B illustrate each a potential result for measuring an electrical resistance using a measurement device according to various aspects compared to conventional measurement devices.

Potential results regarding an ohmmeter's sensitivity may strongly decrease with an increasing resistance above 1 Mega Ohm (i.e., $1M\Omega = 1\,10^6\,\Omega$). For example, this illustrated by **Fig.17A** for different conventional measurement devices 1703 and a measurement device according to various aspects 1704 that is represented by the star-shaped measurement points.. In more detail, a vertical axis 1701 depicts a measurement error in units of parts per million (ppm) and a horizontal axis 1702 represents the electric resistance of a device under test. As may be seen in the diagram, the measurement error of each conventional measurement device increases with increasing resistance.

Furthermore, in order to perform reliable measurements, a test current and/or a test voltage may be significantly increased up to a few hundreds of volts and/or a few hundreds of nano-amperes on the device under test. This is exemplarily depicted in **Fig.17B** for a test voltage and different measurement devices including the conventional measurement devices 1703 and a measurement device 1704 according to various aspects that is represented by the star-shaped measurement points. A vertical axis 1711 represents a typical voltage applied to the device under test in Volts V whereas a horizontal axis 1712 represents an electric resistance of the device under test. As may be seen in the diagram more than 100 V may be necessary to measure electric resistances above $1\,10^9\,\Omega$, i.e., 1 G$\Omega$. These high voltages may not allow to measure sensitive devices, since those may be destroyed by such high voltages. For example, the measurement device according to various aspects may only apply a voltage less than 100 mV (e.g., less than 90 mV, e.g., less than 80 mV, e.g., less than 70 mV, e.g., less than 60 mV, e.g., less than 50 mV, e.g., less than 40 mV, e.g., less than 30 mV, e.g., less than 20 mV, e.g., less than 10 mV, e.g., less than 5 mV) to a device under test to measure an electrical resistance above $10^6$ $\Omega$. A lesser voltage may allow for testing a sensitive device under test, which may be damaged by voltages higher than 1 V.

In the following, various examples are provided that refer to a method for operating a measurement device and a method for determining a physical characteristic.

Example 1 is a measurement device to measure a characteristic electric property of a device to be analyzed, the measurement device may include: a first measurement node and a second measurement node to connect a device to be analyzed; a measurement circuit coupled to the first measurement node and the second measurement node, the measurement circuit may include at least three current injection nodes to inject at least three electric currents (I1, I2, I3) into the measurement circuit, wherein the measurement circuit further includes at least one sensing node, e.g., at least one a current/voltage sensing node as an example, configured to allow for a voltage measurement at the at least one sensing node. The current nodes may be configured to measure a voltage.

Example 2 may be the measurement device according to example 1, may optionally further include at least one voltage measurement device configured to measure an electric potential (e.g., an electric voltage) that may be present at one (e.g., all) of the at least one sensing node.

Example 3 may be the measurement device according to example 1 or 2, wherein each of the at least three current injection nodes correspond to one of the at least one sensing nodes. For example, multiple injection nodes may correspond to only one sensing node. For example, each of the multiple injection nodes may be connected to the same sensing node. In another example, multiple injection nodes may correspond to multiple sensing nodes. For example, a first of the multiple injection nodes may be connected to a first of the multiple sensing nodes and a second of the multiple injection nodes may be connected to a second of the multiple sensing nodes.

Example 4 may be the measurement device according to anyone of examples 1 to 3, wherein each of the at least one sensing node correspond to one of the at least three current injection nodes. For example, one sensing nodes may correspond to one of the at least three current injection nodes. For example, the at least one sensing node are multiple sensing nodes, wherein each of the multiple sensing nodes may correspond to one or more of the at least three current injection nodes.

Example 5 may be the measurement device according to anyone of examples 1 to 4, wherein the at least one sensing node may be multiple sensing nodes, and wherein an amount of the multiple sensing nodes and an amount of the at least three current injection nodes may be equal.

Example 6 may be the measurement device according to anyone of examples 1 to 5, wherein the first measurement node and a first current injection node of the at least three current injection nodes may be connected, e.g., electrically conductive connected, to be on the, e.g., substantially same electrical potential and/or may be provided by a common first connection node.

Example 7 may be the measurement device according to anyone of examples 1 to 6, wherein a first current injection node and a third current injection node of the at least three current injection nodes may constitute a first series connection; wherein the first current injection node, a second current injection node and the third current injection node of the at least three current injection nodes may constitute a second series connection; wherein the first series connection and the second series connection may be connected in parallel to each other.

Example 8 may be the measurement device according to anyone of examples 1 to 7, wherein the second measurement node and a third (e.g., a last) current injection node of the at least three current injection nodes may be electrically conductive connected to be on the, e.g., substantially same electrical potential and/or may be provided by a common second connection node.

Example 9 may be the measurement device according to anyone of examples 1 to 8, wherein the characteristic electric property of a device to be analyzed represents (e.g., is) an electric resistance, an electric conductivity, an electric inductivity and/or an electric capacitance.

Example 10 may be the measurement device according to anyone of examples 1 to 9, may optionally further include a first electrical probe-element having a known characteristic electrical property (e.g., an ohmic resistance, an electric conductance, an electric capacitance, an electric inductivity).

Example 11 may be the measurement device according to example 10, wherein the known characteristic electric property of the first electrical probe-element may be the substantially same electrical property as the electrical property of a device to be analyzed.

Example 12 may be the measurement device according to example 11, wherein a magnitude of (e.g., a value representing) the characteristic electric property of the first electrical probe-element differs from (e.g., may be less than) the magnitude (e.g., a value representing) of the electrical property of a device to be analyzed by more than factor 10, e.g., more than factor 100, e.g., more than factor 1000, e.g., more than factor 10000.

Example 13 may be the measurement device according to anyone of examples 10 to 12, wherein (e.g., via a first terminal of) the first electrical probe-element may be connected, e.g., electrically conductive connected, to the first measurement node

Example 14 may be the measurement device according to anyone of examples 10 to 13, wherein the first electrical probe-element (e.g., a second terminal of the first electrical probe element) may be connected (electrically conductive) to a ground potential (e.g., via a ground terminal).

Example 15 may be the measurement device according to anyone of examples 10 to 14, wherein the first electrical probe-element may be a passive electronic component, wherein the first electrical probe-element is, for example, an electric resistor, a capacitor or an inductor.

Example 16 may be the measurement device according to anyone of examples 1 to 15, may optionally further include a second electrical probe-element having a known electrical property (e.g., an ohmic resistance, an electric conductance, an electric capacitance, an electric inductivity).

Example 17 may be the measurement device according to example 16, wherein the known characteristic electric property of the second electrical probe-element may be the same characteristic electrical property as the electrical property of a device to be analyzed. For example, the characteristic electrical property may be an ohmic resistance, an electric conductance, an electric capacitance, an electric inductivity. For example, the characteristic electrical property of the first and second probe-element may differ by more than factor 2, e.g., by more than factor 3, e.g., by more than factor 4, e.g., by more than factor 5, e.g., by more than factor 7, e.g., by more than factor 10.

Example 18 may be the measurement device according to example 17, wherein a magnitude of (e.g., a value representing) the characteristic electric property of the second electrical probe-element differs from the magnitude (e.g., a value representing) of the electrical property of a device to be analyzed by more than factor 10, e.g., more than factor 100, e.g., more than factor 1000, e.g., more than factor 10000.

Example 19 may be the measurement device according to anyone of examples 16 to 18, wherein (e.g., via a first terminal of) the second electrical probe-element may be connected (electrically conductive) to the second measurement node.

Example 20 may be the measurement device according to anyone of examples 16 to 19, wherein (e.g., via a second terminal of) the second electrical probe-element may be connected (electrically conductive) to a ground potential (e.g., via a ground terminal).

Example 21 may be the measurement device according to anyone of examples 16 to 20, wherein the second electrical probe-element may be a passive electronic component, and wherein the second electrical probe-element is, for example, an electric resistor, a capacitor or an inductor.

Example 22 may be the measurement device according to anyone of examples 10 to 15 in combination with any of examples 16 to 21, wherein a magnitude of (e.g., a value representing) the characteristic electric property of the first electrical probe-element differs from the magnitude (e.g., a value representing) of the electrical property of the second electrical probe-element by less than factor 100, e.g., less than factor 10, e.g., less than factor 5, e.g., less than factor 2.

Example 23 may be the measurement device according to anyone of examples 10 to 15 in combination with any of examples 16 to 22, or according to example 22, wherein the first electrical probe-element and the second electrical probe-element may be passive electronic components according to the same type of passive electronic components, and wherein the first electrical probe-element and the second electrical probe-element may be for example both an electric resistor, a capacitor or an inductor.

Example 24 may be the measurement device according to anyone of examples 1 to 23, wherein the at least three current injection nodes may be an amount of current injection nodes according to any odd number (e.g., prime number) greater than two (e.g., 3, 5, 7, 9, 11, as examples).

Example 25 may be the measurement device according to anyone of examples 1 to 24, wherein a first current may be applied to one current injection node of the at least three current injection nodes, wherein a second current may be applied to another current injection node of the at least three current injection nodes, and wherein the first current may be a function of on the second current or wherein the second current may a function of the first current. For example, the first current and the second current are somehow related to one another but injected into different nodes.

Example 26 may be the measurement device according to anyone of examples 1 to 25, wherein the measurement device may optionally further include a current source configured to provide a set of currents, wherein a first current from the set of currents is applied to one current injection node of the at least three current injection nodes, and a second current from the set of currents is applied another current injection node of the at least three current injection nodes, wherein the first current and second current are correlated with one another. For example, the first current and second current may be correlated with one another in sense of being correlated with one another via being an eigenvector of a resistance matrix or conductance matrix. In one example, the currents source may be a voltage controlled current source. In another example, the current source may be a current controlled current source.

Example 27 may be the measurement device according to anyone of examples 1 to 26, wherein the measurement circuit includes a first-type sub circuit and a second-type sub circuit that may be connected via a interconnect current injection node of the at least three current injection nodes.

Example 28 may be the measurement device according to example 27, wherein the first-type sub circuit may be located between one current injection node (e.g., the first current injection node ) of the at least three current injection nodes and the interconnect current injection node (e.g., the second current injection node ) of the at least three current injection nodes, wherein preferably the one current injection node and the interconnect current injection node may be adjacent (e.g., consecutive) current injection nodes.

Example 29 may be the measurement device according to example 27 or 28, wherein the first-type sub circuit and the second-type sub circuit differ from each other, e.g., at least in one component and/or in an arrangement of the components of the first-type sub circuit and the a second-type sub circuit, respectively. The components of the first-type sub circuit and the second-type sub circuit may be chosen to generate a desired eigenvalue.

Example 30 may be the measurement device according to anyone of examples 27 to 29, wherein the first-type sub circuit includes at least one active element (e.g., operational amplifier) or a device that acts as one (quantum hall) to realize non-Hermitian properties of the characteristic electric property. For example, an additional power supply may be used to operate the least one active element.

It may be understood, that the at least one active element (e.g., operational amplifier) may be realized in another physical system or context or in other functions by a corresponding element, such as a thermally active device including a heat reservoir and a valve or a fluid dynamic active device including a fluid reservoir and a valve, as examples.

Example 31 may be the measurement device according to anyone of examples 27 to 30, wherein the second-type sub circuit includes at least one active element (e.g., operational amplifier) or a device that acts as one (in a quantum hall device, for example) to realize non-Hermitian properties of the characteristic electric property.

It may be understood, that the at least one active element (e.g., operational amplifier) may be realized in another physical system or context or in other functions by a corresponding element, such as a thermally active device including a heat reservoir and a valve or a fluid dynamic active device including a fluid reservoir and a valve, as examples.

Example 32 may be the measurement device according to anyone of examples 27 to 31, wherein (e.g., an input-terminal of) the first-type sub circuit may be connected (electrically conductive) to one current injection node (e.g., the first current injection node) of the at least three current injection nodes, and (e.g., an output-terminal of) the first-type sub circuit may be connected (e.g., electrically conductively connected) to the interconnect current injection node (e.g., the second current injection node) of the at least three current injection nodes, such that the one current injection node, the first-type sub circuit and the interconnect current injection node form a series circuit (e.g., according to the stated order). For example, the one current injection node, the first-type sub circuit and the interconnect current injection node may be connected in serial order as stated in this example.

Example 33 may be the measurement device according to anyone of examples 27 to 32, wherein the second-type sub circuit may be located between the interconnect current injection node (e.g., the second current injection node ) of the at least three current injection nodes and one current injection node (e.g., the third/last current injection node ) of the at least three current injection nodes, and wherein, for example, the interconnect current injection node and the other current injection node may be adjacent (e.g., consecutive) current injection nodes.

Example 34 may be the measurement device according to anyone of examples 27 to 33, wherein (e.g., an input-terminal of) the second-type sub circuit may be connected (e.g., electrically conductively connected) to the interconnect current injection node (e.g., the second current injection node) of the at least three current injection nodes, and (e.g., an output-terminal of) the second-type sub circuit may be connected (e.g., electrically conductively connected) to another current injection node (e.g., the third/last current injection node) of the at least three current injection nodes, such that the interconnect current injection node, the second-type sub circuit and the other current injection node form a series circuit (e.g., according to the stated order). For example, the interconnect current injection node, the second-type sub circuit and the other current injection node may be connected in serial order as stated in this example.

Example 35 is the measurement device according to anyone of examples 27 to 34, wherein the first-type sub circuit includes: a first electronic amplifier, a first sub-circuit probe-element, and a second sub-circuit probe-element. For example, the first electronic amplifier may be powered by a power supply.

Example 36 may be the measurement device according to example 35, wherein the first sub-circuit probe-element and the second sub-circuit probe-element may be passive electronic components according to the same type of passive electronic components, wherein the first sub-circuit probe-element and the second sub-circuit probe-element may be for example both an electric resistor, a capacitor or an inductor.

Example 37 may be the measurement device according to example 35 or 36, wherein the first sub-circuit probe-element and the second sub-circuit probe-element have a known electrical property (e.g., an ohmic resistance, an electric conductance, an electric capacitance, an electric inductivity), respectively.

Example 38 may be the measurement device according to example 37, wherein the known characteristic electric property of the first sub-circuit probe-element and the second sub-circuit probe-element may be the same electrical property as the electrical property of a device to be analyzed.

Example 39 may be the measurement device according to anyone of examples 35 to 38 with example 10, wherein a value representing an (e.g., the) characteristic electric property of the first sub-circuit probe-element may be substantially the same as a value representing an (e.g., the) characteristic electric property of the first electrical probe-element.

Example 40 may be the measurement device according to anyone of examples 35 to 39 with example 10, wherein the first sub-circuit probe-element and the first electrical probe-element may be (subsequently) identically constructed. For example, a respective value representing the characteristic electric property of the first sub-circuit probe-element and the first electrical probe-element may differ less than 25%.

Example 41 may be the measurement device according to anyone of examples 35 to 40 with example 10, wherein a magnitude (e.g., a value representing) of the characteristic electric property of the first sub-circuit probe-element differs from the magnitude (e.g., a value representing) of the electrical property of a device to be analyzed more than factor 10, e.g., more than factor 100, e.g., more than factor 1000, e.g., more than factor 10000.

Example 42 may be the measurement device according to anyone of examples 35 to 41 with example 16, wherein a value representing an (e.g., the) characteristic electric property of the second sub-circuit probe-element may be substantially the same as a value representing an (e.g., the) characteristic electric property of the second electrical probe-element.

Example 43 may be the measurement device according to anyone of examples 35 to 42 with example 16, wherein the second sub-circuit probe-element and the second electrical probe-element may be (subsequently) identically constructed (e.g., value representing the characteristic electric property differs less than 25%).

Example 44 may be the measurement device according to anyone of examples 35 to 43 with example 16, wherein a magnitude (e.g., a value representing) of the characteristic electric property of the second sub-circuit probe-element differs from the magnitude (e.g., a value representing) of the electrical property of a device to be analyzed more than factor 10, e.g., more than factor 100, e.g., more than factor 1000, e.g., more than factor 10000.

Example 45. may be the measurement device according to anyone of examples 35 to 44, wherein the first-type sub circuit may be a parallel connection of the second sub-circuit probe-element and a series connection of the first electronic amplifier and the first sub-circuit probe-element.

Example 46. may be the measurement device according to anyone of examples 35 to 45, the first-type sub circuit further may include: a first-type sub circuit input node and a first-type sub circuit output node, wherein the first-type sub circuit input node may be connected to one current injection nodes of the at least three current injection nodes, and wherein the first-type sub circuit output node may be connected to the interconnect current injection node of the at least three current injection nodes.

Example 47 may be the measurement device according to example 46, wherein first-type sub circuit input node and the one current injection node of the at least three current injection nodes may be connected (e.g., electrically conductively connected) to be on the substantially same electrical potential and/or may be provided by a common node, and/or wherein first-type sub circuit output node and the interconnect current injection node of the at least three current injection nodes may be connected (e.g., electrically conductively connected) to be on the substantially same electrical potential and/or may be provided by a common node.

Example 48 may be the measurement device according to example 46 or 47, wherein the first-type sub circuit input node, the first electronic amplifier, the first sub-circuit probe-element and the first-type sub circuit output node may be connected in series. For example, the first-type sub circuit input node, the first electronic amplifier, the first sub-circuit probe-element and the first-type sub circuit output node may be connected in the stated order. For example, the first-type sub circuit input node, the first electronic amplifier, the first sub-circuit probe-element and the first-type sub circuit output may be connected in serial order as stated in this example. For example, the stated order may be inverted as shown with respect to an inverted first-type sub circuit.

Example 49 may be the measurement device according to example 46 or 48, wherein the first electronic amplifier (e.g., an input-terminal of the first electronic amplifier) may be connected to the first-type sub circuit input node, wherein an output-terminal of the first electronic amplifier may be connected to an input (e.g., another input) of the first electronic amplifier, wherein the output of the first electronic amplifier may be connected to (e.g., an input-terminal of) the first sub-circuit probe-element, and wherein the first sub-circuit probe-element (e.g., an output-terminal of the first sub-circuit probe-element) may be connected to the first-type sub circuit output node.

Example 50 may be the measurement device according to anyone of examples 46 to 49, wherein the second sub-circuit probe-element may be connected to a first-type sub circuit input node (e.g., connected via an input-terminal of the second sub-circuit probe-element) and may be connected to a first-type sub circuit output node (e.g., connected via an output-terminal of the second sub-circuit probe-element).

Example 51 is the measurement device according to anyone of examples 27 to 50, wherein the second-type sub circuit includes: a second electronic amplifier, and a third sub-circuit probe-element. For example, the second electronic amplifier may be powered by a power supply.

Example 52 may be the measurement device according to example 51, wherein the third sub-circuit probe-element may be a passive electronic component, and wherein the third sub-circuit probe-element is, for example, an electric resistor, a capacitor or an inductor.

Example 53 may be the measurement device according to anyone of examples 51 to 52, wherein the third sub-circuit probe-element has a known electrical property (e.g., an ohmic resistance, an electric conductance, an electric capacitance, an electric inductivity), respectively.

Example 54 may be the measurement device according to example 53, wherein the known characteristic electric property of the third sub-circuit probe-element may be the same electrical property as the electrical property of a device to be analyzed.

Example 55 may be the measurement device according to anyone of examples 51 to 54 with example 10, wherein a value representing an (e.g., the) characteristic electric property of the third sub-circuit probe-element may be substantially the same as a value representing an (e.g., the) characteristic electric property of the first electrical probe-element.

Example 56 may be the measurement device according to anyone of examples 51 to 55 with example 10, wherein the third sub-circuit probe-element and the first electrical probe-element may be substantially identically constructed (e.g., value representing the characteristic electric property differs less than 25%).

Example 57 may be the measurement device according to anyone of examples 51 to 56 with example 10, wherein a magnitude (e.g., a value representing) of the characteristic electric property of third sub-circuit probe-element differs from the magnitude (e.g., a value representing) of the electrical property of a device to be analyzed more than factor 10, e.g., more than factor 100, e.g., more than factor 1000, e.g., more than factor 10000.

Example 58 is the measurement device according to anyone of examples 51 to 57, the second-type sub circuit further may include: a second-type sub circuit input node and a second-type sub circuit output node, wherein the second-type sub circuit input node may be connected to the interconnect current injection node of the at least three current injection nodes, and wherein the second-type sub circuit output node may be connected to another current injection node of the at least three current injection nodes.

Example 59 may be the measurement device according to example 58, wherein second-type sub circuit input node and the interconnect current injection node of the at least three current injection nodes may be connected (e.g., electrically conductively connected) to be on the substantially same electrical potential and/or may be provided by a common node, and/or wherein second-type sub circuit output node and the other current injection node of the at least three current injection nodes may be connected (e.g., electrically conductively connected) to be on the substantially same electrical potential and/or may be provided by a common node.

Example 60 may be the measurement device according to example 46 or 59, wherein the second-type sub circuit input node, the second electronic amplifier, the third sub-circuit probe-element and the second-type sub circuit output node may be connected in series. For example, the second-type sub circuit input node, the second electronic amplifier, the third sub-circuit probe-element and the second-type sub circuit output node may be connected in the stated order. For example, the second-type sub circuit input node, the second electronic amplifier, the third sub-circuit probe-element and the second-type sub circuit output node may be connected in serial order as stated in this example. For example, the stated order may be inverted as shown with respect to an inverted second-type sub circuit.

Example 61 may be the measurement device according to example 58 or 60, wherein an input-terminal of the second electronic amplifier may be connected to the second-type sub circuit input node, wherein an output-terminal of the second electronic amplifier may be connected to another input of the second electronic amplifier, wherein the output of the second electronic amplifier may be connected to the first sub-circuit probe-element (e.g., an input-terminal of the first sub-circuit probe-element), and wherein the first sub-circuit probe-element (e.g., an output-terminal of the first sub-circuit probe-element) may be connected to the first-type sub circuit output node.

Example 62 may be the measurement device according to anyone of examples 1 to 26, wherein the measurement circuit may further include a set of first-type sub circuits each according to a first-type sub circuit according to anyone of examples 35 to 50; a set of second-type sub circuits each according to a second-type sub circuit according to anyone of examples 51 to 61; wherein the at least three injection nodes may be an odd number of injection nodes, wherein the number of the at least three injection nodes may be greater than three.

Example 63 may be the measurement device according to example 62, wherein an amount of first-type sub circuits of the set of first-type sub circuits and an amount of second-type sub circuits of the set of second-type sub circuits may be equal.

Example 64 is the measurement device according to example 62 or 63, wherein the first-type sub circuits of the set of first-type sub circuits and the second-type sub circuits of the set of second-type sub circuits may be connected in series in an alternating order to form a row of sub circuits starting with a first-type sub circuit and ending with a second-type sub circuit, and wherein the adjacent sub circuits of the row of sub circuits may be connected via one respective current injection node of the at least three current injection nodes.

Example 65 may be the measurement device according to example 64, wherein all adjacent first-type sub circuits and second-type sub circuits within the row of sub circuits may be connected via a corresponding injection node of the at least three injection nodes (i.e. one injection node may be located between adjacent sub circuits), and wherein all adjacent second-type sub circuits and first-type sub circuits within the row of sub circuits may be connected via a corresponding injection node of the at least three injection nodes (i.e. one injection node may be located between adjacent sub circuits).

Example 66 may be the measurement device according to anyone of examples 62 to 65, wherein a first-type sub circuit of the set of first-type sub circuits that may be the first (e.g., the beginning) sub circuit of the row of sub circuits may be (e.g., its first-type sub circuit input node) connected to a first injection node of the at least three injection nodes.

Example 67 may be the measurement device according to anyone of examples 62 to 66, wherein a second-type sub circuit of the set of first-type sub circuits that may be the last sub circuit of the row of sub circuits may be (e.g., its second-type sub circuit output node) connected to a last injection node of the at least three injection nodes.

Example 68 may be the measurement device according to anyone of examples 62 to 67, wherein at least two of the at least three injection nodes may be connected via a first connection and via a second connection, wherein the first connection includes at least one further injection node of the at least three injection nodes; and wherein the first connection and the second connection may be connected in parallel to each other. For example, the second connection, may be a bypass to the first connection. For example, the second connection may be configured to bypass the at least one further injection node of the at least three injection nodes.

Example 69 may be a measurement device to measure a physical characteristic of a device to be analyzed, the measurement device may include: first measurement node and a second measurement node to connect a device to be analyzed; and a measurement circuit coupled to the first measurement node and the second measurement node, the measurement circuit may include at least three physical injection nodes to inject a physical input quantity that may be represented by at least three values (I1, I2, I3) into the measurement circuit, wherein the measurement circuit may further include at least one physical output (strongly influenced) quantity sensing node configured to allow for a physical quantity measurement at the at least one physical output quantity sensing node.

Example 70 may be a method for determining a physical characteristic, whereby the physical characteristic to be determined may be correlated to a physical input quantity and a physical output quantity, wherein a measurement setup may be used that represents the correlation between the physical input quantity, the physical output quantity and the physical characteristic to be determined via a non-Hermitian Matrix, wherein the measurement setup includes at least three input nodes (e.g., an odd number of input nodes greater than 1) for providing the physical input quantity to the measurement setup; the method may include: applying the physical input quantity to the at least three input nodes of the measurement setup, whereby the physical input quantity represents a predetermined input vector; measuring the physical output quantity that is (e.g., may represent) an output vector of the measurement setup, wherein the output vector is proportional to the input vector; and determining the physical characteristic to be determined based on the correlation of the input vector, the eigenvalue of the non-Hermitian Matrix and the measured output vector or based on a comparison of a predetermined threshold-value and the eigenvalue of the non-Hermitian Matrix being determined based on the measured output vector.

Example 71 is a method for determining a physical characteristic and/or a variation of the physical characteristic of a device to be tested. In an electrical system the characteristic may be a conductivity or a resistance and, correspondingly, the respective variation may be a difference the conductivity or a difference of the resistivity, e.g., with respect to the initial value. The method includes: applying a physical input quantity as a predetermined input vector to at least three input nodes of a measurement setup, the measurement setup being connected to the device to be tested; measuring a physical output quantity of the measurement setup as measured output vector, wherein the measured output vector is a function of the predetermined input vector and the physical characteristic; and determining the physical characteristic and/or the variation of the physical characteristic based on the measured output vector.

Example 72 is the method according to example 71, wherein the measured output vector and the predetermined input vector are correlated through a non-Hermitian Matrix representing the measurement setup and the physical characteristic of the device to be tested.

Example 73 is the method according to example 71 or 72, wherein the predetermined input vector is substantially an eigenvector of a non-Hermitian Matrix representing the measurement setup.

Example 74 is the method according to anyone of examples of 71 to 73, wherein applying the physical input quantity as the predetermined input vector may include: determining a non-Hermitian Matrix representing the measurement setup; determining an eigenvector of the non-Hermitian Matrix representing the measurement setup; and applying the eigenvector as the predetermined input vector to the measurement setup. For example, the determining of the non-Hermitian Matrix representing the measurement setup may be performed in an initial step, wherein the device to be tested is not connected to the measurement setup.

Example 75 is a method for operating a measurement setup, the method including: determining a non-Hermitian Matrix representing the measurement setup; determining an eigenvector of the non-Hermitian Matrix representing the measurement setup; and applying the eigenvector as an input vector to the measurement setup to determine a physical characteristic of a device to be tested based on an output vector of the measurement setup caused by applying the input vector to the measurement setup. For example, the determining of the non-Hermitian Matrix representing the measurement setup may be performed in an initial step, wherein the device to be tested is not connected to the measurement setup.

Example 76 may be the measurement device according to example 69 or the method according to anyone of the examples 70 to 75, whereby the physical input quantity (e.g., the input vector) is proportional to an eigenvector of the non-Hermitian Matrix; and/or wherein the least one physical output (e.g., the output vector) is proportional to at least one eigenvalue of the non-Hermitian Matrix.

Example 77 may be the measurement device according to example 69 or 76 the method according to anyone of the examples 70 to 75 or according to example 76, wherein the physical characteristic to be determined may be an electric characteristic, e.g., a resistance, a inductivity, a capacitance, a conductivity. For example, the physical input quantity may be an electric current and the physical output quantity may be an electric voltage. For example, the physical input quantity may be an electric voltage and the physical output quantity may be an electric current. The non-Hermitian Matrix may be, for example, a conductance matrix.

Example 78 may be the measurement device according to anyone of examples 69, 76 or 77 or the method according to anyone of the examples 70 to 75 or to example 76 or 77, wherein the physical characteristic to be determined may be a characteristic of a fluid, e.g., a flow-resistance of the/to the fluid. For example, the physical input quantity may be a volumetric flow rate of the fluid and the physical output quantity may be a pressure resulting in the fluid. For example, the physical input quantity may be a pressure applied to the fluid and the physical output quantity may be a resulting volumetric flow rate of the fluid. In such a system, the active element may be implemented by a fluid dynamic active device including a fluid reservoir and a valve. A power supply may be implemented by a pump device or similar.

Example 79 may be the measurement device according to anyone of examples 69, 76 to 78 or the method according to anyone of the examples 70 to 75 or to anyone of examples 76 to 78, wherein the physical characteristic to be determined may be a characteristic temperature distribution, e.g., a thermal resistance. For example, the physical input quantity may be a heat flow and the physical output quantity may be a resulting temperature difference. For example, the physical input quantity may be a predetermined temperature difference and the physical output quantity may be a resulting heat flow. In such a system, the active element may be implemented by a device including a heat reservoir and a valve. A power supply may be implemented by a heater-device or similar.

**Claims**

1.  A measurement device (100) to measure a characteristic electric property of a device to be analyzed (10), the measurement device (100) comprising:

    a first measurement node (102) and a second measurement node (104) configured to connect a device to be analyzed (10);
a measurement circuit (200) coupled to the first measurement node (102) and the second measurement node (104), the measurement circuit (200) comprising at least three current injection nodes (210) to inject at least three electric currents (I1, I2, I3) into the measurement circuit (200),
wherein the measurement circuit further comprises at least one (current/voltage) sensing node (220) configured to allow for a current/voltage measurement at the at least one (current/voltage) sensing node.

2. The measurement device (100) according to claim 1, further comprising
at least one voltage measurement device configured to measure an electric potential that is present at one of the at least one sensing node (220).

3. The measurement device (100) according to claim 1 or 2,

   wherein each of the at least three current injection nodes (210) correspond to one of the at least one sensing nodes (220), and/or
   wherein each of the at least one sensing node (220) correspond to one of the at least three current injection nodes (210).

4. The measurement device (100) according to anyone of claims 1 to 3,
wherein the characteristic electric property of a device to be analyzed (10) represents an electric resistance, an electric conductivity, an electric inductivity and/or an electric capacitance.

5. The measurement device (100) according to anyone of claims 1 to 4, further comprising

   a first electrical probe-element (106) having a known characteristic electrical property, preferably a known ohmic resistance, a known electric conductance, a known electric capacitance and/or a known electric inductivity; and/or
   a second electrical probe-element (108) having a known electrical property, preferably a known ohmic resistance, a known electric conductance, a known electric capacitance and/or a known electric inductivity.

6. The measurement device (100) according to claim 5,

   wherein the first electrical probe-element (106) is a passive electronic component, and wherein the first electrical probe-element (106) is more preferably an electric resistor, a capacitor or an inductor; and/or
   wherein the second electrical probe-element (108) is a passive electronic component, and wherein the second electrical probe-element (108) is more preferably an electric resistor, a capacitor or an inductor.

7. The measurement device (100) according to anyone of claims 1 to 6,
wherein the at least three current injection nodes (210) are an amount of current injection nodes according to any odd number greater than two.

8. The measurement device (100) according to anyone of claims 1 to 7, further comprising:

   a current source configured to provide a set of currents,
   wherein a first current from the set of currents is applied to one current injection node of the at least three current injection nodes (210), and a second current from the set of currents is applied another current injection node of the at least three current injection nodes (210),
   wherein the first current and second current are correlated with one another; and
   wherein the currents source is, more preferably, a voltage controlled current source or a current controlled current source.

9. The measurement device (100) according to anyone of claims 1 to 8,
wherein the measurement circuit comprises a first-type sub circuit (230) and a second-type sub circuit (240) that are connected via an interconnect current injection node (210-C) of the at least three current injection nodes (210).

10. The measurement device (100) according to claim 9,

    wherein the first-type sub circuit (230) comprises at least one active element or a device that acts as an active element to realize non-Hermitian properties of the characteristic electric property; and/or
wherein the second-type sub circuit (240) comprises at least one active element or a device that acts as an active element to realize non-Hermitian properties of the characteristic electric property.

11. The measurement device (100) according to claim 9 or 10, wherein the first-type sub circuit (230) comprises:

a first electronic amplifier (231),
a first sub-circuit probe-element (232), and
a second sub-circuit probe-element (233);
wherein the first sub-circuit probe-element (232) and the second sub-circuit probe-element (233) are more preferably both an electric resistor, a capacitor or an inductor.

12. The measurement device (100) according to anyone of claims 9 to 11, wherein the second-type sub circuit (240) comprises:

a second electronic amplifier (241), and
a third sub-circuit probe-element (242);
wherein the third sub-circuit probe-element (242) is more preferably an electric resistor, a capacitor or an inductor.

13. A method for determining a physical characteristic and/or a variation of the physical characteristic of a device to be tested,

applying a physical input quantity as a predetermined input vector to at least three input nodes of a measurement setup, the measurement setup being connected to the device to be tested;
measuring a physical output quantity of the measurement setup as measured output vector, wherein the measured output vector is a function of the predetermined input vector and the physical characteristic; and
determining the physical characteristic and/or the variation of the physical characteristic based on the measured output vector.

14. The method according to claim 13,

wherein the measured output vector and the predetermined input vector are correlated through a non-Hermitian Matrix representing the measurement setup and the physical characteristic of the device to be tested; and/or
wherein the predetermined input vector is substantially an eigenvector of a non-Hermitian Matrix representing the measurement setup.

15. A method for operating a measurement setup, which is a measurement device of any one of claims 1 to 12, the method comprising:

determining a non-Hermitian Matrix representing the measurement setup;
determining an eigenvector of the non-Hermitian Matrix representing the measurement setup;
applying the eigenvector as an input vector to the measurement setup to determine a physical characteristic of a device to be tested based on an output vector of the measurement setup caused by applying the input vector to the measurement setup.

**Patentansprüche**

1. Messvorrichtung (100) zum Messen einer charakteristischen elektrischen Eigenschaft einer zu untersuchenden Vorrichtung (10), die Messvorrichtung (100) aufweisend:

einen ersten Messknoten (102) und einen zweiten Messknoten (104), die eingerichtet sind , eine zu analysierende Vorrichtung (10) anzuschließen;
eine Messschaltung (200), die mit dem ersten Messknoten (102) und dem zweiten Messknoten (104) gekoppelt ist, wobei die Messschaltung (200) mindestens drei Strominjektionsknoten (210) aufweist, um mindestens drei elektrische Ströme (I1, I2, I3) in die Messschaltung (200) zu injizieren,
wobei die Messschaltung weiterhin mindestens einen (Strom-/Spannungs-)Messknoten (220) aufweist, der eingerichtet ist, eine Strom-/Spannungsmessung an dem mindestens einen (Strom-/Spannungs-)Messknoten zu ermöglichen.

2. Messvorrichtung (100) nach Anspruch 1, ferner aufweisend mindestens eine Vorrichtung zum Spannungsmessen, eingerichtet zum Messen eines elektrischen Potentials, das an einem der mindestens einen Messknoten (220) vorhanden ist.

3. Messvorrichtung (100) ng nach Anspruch 1 oder 2,

   wobei jeder der mindestens drei Strominjektionsknoten (210) zu einem der mindestens einen Sensorknoten (220) korrespondiert, und/oder
   wobei jeder der mindestens einen Messknoten (220) zu einem der mindestens drei Stromeinspeiseknoten (210) korrespondiert.

4. Messvorrichtung (100) nach einem der Ansprüche 1 bis 3, wobei die charakteristische elektrische Eigenschaft einer zu untersuchenden Vorrichtung (10) einen elektrischen Widerstand, eine elektrische Leitfähigkeit, eine elektrische Induktivität und/oder eine elektrische Kapazität darstellt.

5. Messvorrichtung (100) nach einem der Ansprüche 1 bis 4, ferner aufweisend

   ein erstes elektrisches Sondenelement (106) mit einer bekannten charakteristischen elektrischen Eigenschaft, vorzugsweise einem bekannten ohmschen Widerstand, einem bekannten elektrischen Leitwert, einer bekannten elektrischen Kapazität und/oder einer bekannten elektrischen Induktivität; und/oder
   ein zweites elektrisches Sondenelement (108) mit einer bekannten elektrischen Eigenschaft, vorzugsweise einem bekannten ohmschen Widerstand, einer bekannten elektrischen Leitfähigkeit, einer bekannten elektrischen Kapazität und/oder einer bekannten elektrischen Induktivität.

6. Messvorrichtung (100) nach Anspruch 5,

   wobei das erste elektrische Sondenelement (106) ein passives elektronisches Bauelement ist, und wobei das erste elektrische Sondenelement (106) vorzugsweise ein elektrischer Widerstand, ein Kondensator oder eine Spule ist; und/oder
   wobei das zweite elektrische Sondenelement (108) ein passives elektronisches Bauelement ist, und wobei das zweite elektrische Sondenelement (108) vorzugsweise ein elektrischer Widerstand, ein Kondensator oder eine Induktivität ist.

7. Messvorrichtung (100) nach einem der Ansprüche 1 bis 6, wobei die mindestens drei Strominjektionsknoten (210) eine Anzahl von Strominjektionsknoten sind, die zu einer ungeraden Zahl größer als zwei korrespondiert.

8. Messvorrichtung (100) nach einem der Ansprüche 1 bis 7, ferner aufweisend:

   eine Stromquelle, die eingerichtet ist, einen Satz von Strömen bereitzustellen,
   wobei ein erster Strom aus dem Satz von Strömen an einen Strominjektionsknoten der mindestens drei Strominjektionsknoten (210) zugeführt wird, und ein zweiter Strom aus dem Satz von Strömen an einen anderen Strominjektionsknoten der mindestens drei Strominjektionsknoten (210) zugeführt wird,
   wobei der erste Strom und der zweite Strom miteinander korreliert sind; und
   wobei die Stromquelle vorzugsweise eine spannungsgesteuerte Stromquelle oder eine stromgesteuerte Stromquelle ist.

9. Messvorrichtung (100) nach einem der Ansprüche 1 bis 8, wobei die Messschaltung eine Teilschaltung (230) eines ersten Typs und eine Teilschaltung (240) eines zweiten Typs aufweist, die über einen Zwischenverbindungs-Strominjektionsknoten (210-C) der mindestens drei Strominjektionsknoten (210) verbunden sind.

10. Messvorrichtung (100) nach Anspruch 9,

    wobei die Teilschaltung (230) des ersten Typs mindestens ein aktives Element oder eine Vorrichtung aufweist, die als aktives Element wirkt, um nicht-hermitsche Eigenschaften der charakteristischen elektrischen Eigenschaft zu realisieren; und/oder
    wobei die Teilschaltung (240) des zweiten Typs mindestens ein aktives Element oder eine Vorrichtung aufweist, die als aktives Element wirkt, um nicht-hermitsche Eigenschaften der charakteristischen elektrischen Eigenschaft zu realisieren.

**11.** Messvorrichtung (100) nach Anspruch 9 oder 10, wobei die erste Teilschaltung (230) aufweist:

einen ersten elektronischen Verstärker (231),
ein erstes Teilschaltung-Sondenelement (232) und
eine zweites Teilschaltung-Sondenelement (233);
wobei das erste Teilschaltung-Sondenelement (232) und das zweite Teilschaltung-Sondenelement (233) vorzugsweise beide ein elektrischer Widerstand, ein Kondensator oder eine Spule sind.

**12.** Messvorrichtung (100) nach einem der Ansprüche 9 bis 11, wobei die zweite Teilschaltung (240) aufweist:

einen zweiten elektronischen Verstärker (241), und
eine dritte Teilschaltung-Sondenelement (242);
wobei das dritte Teilschaltung-Sondenelement (242) vorzugsweise ein elektrischer Widerstand, ein Kondensator oder eine Induktivität ist.

**13.** Verfahren zum Ermitteln einer physikalischen Eigenschaft und/oder einer Veränderung der physikalischen Eigenschaft einer zu untersuchenden Vorrichtung,

Anlegen einer physikalischen Eingangsgröße als vorgegebener Eingangsvektor an mindestens drei Eingangsknoten einer Messanordnung, wobei die Messanordnung mit der zu prüfenden Vorrichtung verbunden ist;
Messen einer physikalischen Ausgangsgröße der Messanordnung als gemessener Ausgangsvektor, wobei der gemessene Ausgangsvektor eine Funktion des vorbestimmten Eingangsvektors und der physikalischen Eigenschaft ist; und
Ermitteln der physikalischen Eigenschaft und/oder der Variation der physikalischen Eigenschaft basierend auf dem gemessenen Ausgangsvektor.

**14.** Verfahren nach Anspruch 13,

wobei der gemessene Ausgangsvektor und der vorbestimmte Eingangsvektor durch eine nicht-hermitsche Matrix korreliert sind, die den Messaufbau und die physikalische Eigenschaft der zu prüfenden Vorrichtung darstellt; und/oder
wobei der vorbestimmte Eingangsvektor im Wesentlichen ein Eigenvektor einer nicht-hermitschen Matrix ist, die die Messanordnung darstellt.

**15.** Verfahren zum Betreiben einer Messanordnung, die eine Vorrichtung nach einem der Ansprüche 1 bis 12 ist, wobei das Verfahren aufweist:

Ermitteln einer nicht-hermitschen Matrix, die den Messaufbau darstellt;
Ermitteln eines Eigenvektors der nicht-hermitischen Matrix, die die Messanordnung darstellt;
Anwenden des Eigenvektors als Eingangsvektor auf die Messanordnung, um eine physikalische Eigenschaft einer zu prüfenden Vorrichtung basierend auf einem Ausgangsvektor der Messanordnung zu ermitteln, der durch Anwenden des Eingangsvektors auf die Messanordnung verursacht wird.

**Revendications**

**1.** Dispositif de mesure (100) pour mesurer une propriété électrique caractéristique d'un dispositif à analyser (10), le dispositif de mesure (100) comprenant :

un premier nœud de mesure (102) et un deuxième nœud de mesure (104) configurés pour connecter un dispositif à analyser (10) ;
un circuit de mesure (200) couplé au premier nœud de mesure (102) et au deuxième nœud de mesure (104), le circuit de mesure (200) comprenant au moins trois nœuds d'injection de courant (210) pour injecter au moins trois courants électriques (I1, I2, I3) dans le circuit de mesure (200),
dans lequel le circuit de mesure comprend en outre au moins un nœud de détection (de courant/tension) (220) configuré pour permettre une mesure de courant/tension au niveau dudit au moins un nœud de détection (de courant/tension).

2. Dispositif de mesure (100) selon la revendication 1, comprenant en outre :
   au moins un dispositif de mesure de tension configuré pour mesurer un potentiel électrique présent à l'un dudit au moins un nœud de détection (220).

3. Dispositif de mesure (100) selon la revendication 1 ou 2,

   dans lequel chacun desdits au moins trois nœuds d'injection de courant (210) correspond à l'un dudit au moins un nœud de détection (220), et/ou
   dans lequel chacun dudit au moins un nœud de détection (220) correspond à l'un desdits au moins trois nœuds d'injection de courant (210).

4. Dispositif de mesure (100) selon l'une quelconque des revendications 1 à 3,
   dans lequel la propriété électrique caractéristique d'un dispositif à analyser (10) représente une résistance électrique, une conductivité électrique, une inductance électrique et/ou une capacité électrique.

5. Dispositif de mesure (100) selon l'une quelconque des revendications 1 à 4, comprenant en outre :

   un premier élément de sonde électrique (106) ayant une propriété électrique caractéristique connue, de préférence une résistance ohmique connue, une conductance électrique connue, une capacité électrique connue et/ou une inductance électrique connue ; et/ou
   un deuxième élément de sonde électrique (108) ayant une propriété électrique connue, de préférence une résistance ohmique connue, une conductance électrique connue, une capacité électrique connue et/ou une inductance électrique connue.

6. Dispositif de mesure (100) selon la revendication 5,

   dans lequel le premier élément de sonde électrique (106) est un composant électronique passif, et dans lequel le premier élément de sonde électrique (106) est plus préférentiellement une résistance électrique, un condensateur ou un inducteur ; et/ou
   dans lequel le deuxième élément de sonde électrique (108) est un composant électronique passif, et dans lequel le deuxième élément de sonde électrique (108) est plus préférablement une résistance électrique, un condensateur ou un inducteur.

7. Dispositif de mesure (100) selon l'une quelconque des revendications 1 à 6,
   dans lequel lesdits au moins trois nœuds d'injection de courant (210) sont une quantité de nœuds d'injection de courant selon tout nombre impair supérieur à deux.

8. Dispositif de mesure (100) selon l'une quelconque des revendications 1 à 7, comprenant en outre :

   une source de courant configurée pour fournir un ensemble de courants,
   dans lequel un premier courant de l'ensemble de courants est appliqué à un nœud d'injection de courant desdits au moins trois nœuds d'injection de courant (210), et un deuxième courant de l'ensemble de courants est appliqué à un autre nœud d'injection de courant desdits au moins trois nœuds d'injection de courant (210), dans lequel le premier courant et le deuxième courant sont corrélés l'un à l'autre ; et
   dans lequel la source de courant est, plus préférentiellement, une source de courant commandée en tension ou une source de courant commandée en courant.

9. Dispositif de mesure (100) selon l'une quelconque des revendications 1 à 8,
   dans lequel le circuit de mesure comprend un sous-circuit de premier type (230) et un sous-circuit de deuxième type (240) qui sont connectés via un nœud d'injection de courant d'interconnexion (210-C) desdits au moins trois nœuds d'injection de courant (210).

10. Dispositif de mesure (100) selon la revendication 9,

   dans lequel le sous-circuit de premier type (230) comprend au moins un élément actif ou un dispositif qui agit comme un élément actif pour réaliser des propriétés non hermitiennes de la propriété électrique caractéristique ; et/ou

dans lequel le sous-circuit de deuxième type (240) comprend au moins un élément actif ou un dispositif qui agit comme un élément actif pour réaliser des propriétés non hermitiennes de la propriété électrique caractéristique.

**11.** Dispositif de mesure (100) selon la revendication 9 ou 10, dans lequel le sous-circuit de premier type (230) comprend :

un premier amplificateur électronique (231),
un premier élément de sonde de sous-circuit (232), et
un deuxième élément de sonde de sous-circuit (233) ;
dans lequel le premier élément de sonde de sous-circuit (232) et le deuxième élément de sonde de sous-circuit (233) sont plus préférentiellement tous les deux une résistance électrique, un condensateur ou un inducteur.

**12.** Dispositif de mesure (100) selon l'une quelconque des revendications 9 à 11, dans lequel le sous-circuit de deuxième type (240) comprend :

un deuxième amplificateur électronique (241), et
un troisième élément de sonde de sous-circuit (242) ;
dans lequel le troisième élément de sonde de sous-circuit (242) est plus préférentiellement une résistance électrique, un condensateur ou un inducteur.

**13.** Procédé pour déterminer une caractéristique physique et/ou une variation de la caractéristique physique d'un dispositif à tester,

appliquer une quantité d'entrée physique en tant que vecteur d'entrée prédéterminé à au moins trois nœuds d'entrée d'une configuration de mesure, la configuration de mesure étant connectée au dispositif à tester ;
mesurer une quantité de sortie physique de la configuration de mesure en tant que vecteur de sortie mesuré, le vecteur de sortie mesuré étant une fonction du vecteur d'entrée prédéterminé et de la caractéristique physique ; et
déterminer la caractéristique physique et/ou la variation de la caractéristique physique sur la base du vecteur de sortie mesuré.

**14.** Procédé selon la revendication 13,

dans lequel le vecteur de sortie mesuré et le vecteur d'entrée prédéterminé sont corrélés par l'intermédiaire d'une matrice non hermitienne représentant la configuration de mesure et la caractéristique physique du dispositif à tester ; et/ou
dans lequel le vecteur d'entrée prédéterminé est substantiellement un vecteur propre d'une matrice non hermitienne représentant la configuration de mesure.

**15.** Procédé d'exploitation d'une configuration de mesure, qui est un dispositif de mesure selon l'une quelconque des revendications 1 à 12, le procédé comprenant :

déterminer une matrice non hermitienne représentant la configuration de mesure ;
déterminer un vecteur propre de la matrice non hermitienne représentant la configuration de mesure ;
appliquer le vecteur propre comme vecteur d'entrée à la configuration de mesure pour déterminer une caractéristique physique d'un dispositif à tester sur la base d'un vecteur de sortie de la configuration de mesure provoqué par l'application du vecteur d'entrée à la configuration de mesure.

FIG. 1

EP 4 394 400 B1

# FIG. 2

## FIG. 3A

## FIG. 3B

# FIG. 3C

# FIG. 4

EP 4 394 400 B1

# FIG. 5

EP 4 394 400 B1

FIG. 6A

230

230-1

231-1
231-2
231
231-3

233-1
233
233-2

232-1
232
232-2

230-2

210-C

FIG. 6B

FIG. 6C

EP 4 394 400 B1

FIG. 6D

230(mi)

210-C

230-1

231-1
231-2
231-E
231-3

233-1
233-E
233-2

232-1

232-E
232-2
230-2

FIG. 7A

FIG. 7B

EP 4 394 400 B1

EP 4 394 400 B1

# FIG. 7C

# FIG. 7D

EP 4 394 400 B1

FIG. 8A

EP 4 394 400 B1

FIG. 8B

EP 4 394 400 B1

FIG. 9

FIG. 10

EP 4 394 400 B1

# FIG. 11

1100

Applying a physical input quantity to a measurement setup ⟋1110

Measuring a physical output quantity as an output of the measurement setup ⟋1120

Determining a physical characteristic ⟋1130

# FIG. 12A

# FIG. 12B

# FIG. 13A

EP 4 394 400 B1

**FIG. 13B**

EP 4 394 400 B1

FIG. 14A

EP 4 394 400 B1

# FIG. 14B

EP 4 394 400 B1

**FIG. 15**

# FIG. 16A

**FIG. 16B**

FIG. 17A

FIG. 17B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20180143227 A1
- US 2015308973 A1
- JP 2006010572 A
- JP 2013053858 A